(19) 

**Europäisches Patentamt**
**European Patent Office**
**Office européen des brevets**

(11) **EP 2 522 013 B1**

(12) **EUROPEAN PATENT SPECIFICATION**

(45) Date of publication and mention
of the grant of the patent:
**27.11.2013 Bulletin 2013/48**

(21) Application number: **11706518.5**

(22) Date of filing: **22.02.2011**

(51) Int Cl.:
***G10L 19/018*** (2013.01)

(86) International application number:
**PCT/EP2011/052622**

(87) International publication number:
**WO 2011/104243 (01.09.2011 Gazette 2011/35)**

(54) **Watermark generator, watermark decoder, method for providing a watermark signal in dependence on binary message data, method for providing binary message data in dependence on a watermarked signal and computer program using a two-dimensional bit spreading**

Wasserzeichenerzeuger, Wasserzeichendekodierer, Verfahren zur Bereitstellung eines Wasserzeichensignals in Abhängigkeit binärer Benachrichtigungsdaten, Verfahren zur Bereitstellung binärer Benachrichtigungsdaten in Abhängigkeit eines Wasserzeichensignals und Computerprogramm mit zweidimensionaler Bit-Verbreiterung

Générateur de filigrane, décodeur de filigrane, procédé de fourniture d'un signal de filigrane dépendant de données de message binaires, procédé de fourniture de données de message binaires dépendantes d'un signal de filigrane et programme informatique utilisant un étalement de bits bidimensionnel

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **26.02.2010 EP 10154960**

(43) Date of publication of application:
**14.11.2012 Bulletin 2012/46**

(73) Proprietor: **Fraunhofer-Gesellschaft zur
Förderung der
angewandten Forschung e.V.
80686 München (DE)**

(72) Inventors:
• **WABNIK, Stefan
  26129 Oldenburg (DE)**
• **PICKEL, Jörg
  91230 Happurg (DE)**
• **GREEVENBOSCH, Bert
  NL-3069 AR Rotterdam (NL)**
• **GRILL, Bernhard
  91207 Lauf (DE)**
• **EBERLEIN, Ernst
  91091 Großenseebach (DE)**
• **DEL GALDO, Giovanni
  98693 Martinroda (DE)**
• **KRÄGELOH, Stefan
  91056 Erlangen (DE)**

• **ZITZMANN, Reinhard
  90183 Baiersdorf (DE)**
• **BLIEM, Tobias
  91058 Erlangen (DE)**
• **BREILING, Marco
  91052 Erlangen (DE)**
• **BORSUM, Juliane
  91058 Erlangen (DE)**

(74) Representative: **Burger, Markus et al
Schoppe Zimmermann
Stöckeler Zinkler & Partner
Postfach 246
82043 Pullach (DE)**

(56) References cited:
**DE-A1-102008 014 311**

• **KIROVSKI D ET AL: "Robust Covert
  communication over a Public Audio Channel
  using Spread Spectrum", LECTURE NOTES IN
  COMPUTER SCIENCE, [Online] vol. 2137/2001, 1
  January 2001 (2001-01-01), pages 354-368,
  XP002590801, Berlin/Heidelberg Retrieved from
  the Internet: URL:http://www.springerlink.com/
  content/20 e7cu8c86lfmw9m/fulltext.pdf>**

**(Cont. next page)**

- KIROVSKI D ET AL: "Spread-spectrum audio watermarking: requirements, applications, and limitations", MULTIMEDIA SIGNAL PROCESSING, 3 October 2001 (2001-10-03), pages 219-224, XP010565778, 2001 IEEE FOURTH WORKSHOP PISCATAWAY, NJ, USA ISBN: 978-0-7803-7025-8

**Description**

Technical Field

Embodiments according to the invention are related to a watermark generator for providing a watermark signal in dependence on binary message data. Further embodiments according to the invention relate to a watermark decoder for providing binary message data in dependence on a watermarked signal. Further embodiments according to the invention are related to a method for providing a watermark signal in dependence on binary message data. Further embodiments according to the invention are related to a method for providing binary message data in dependence on a watermarked signal. Further embodiments are related to corresponding computer programs.

Some embodiments according to the invention are related to a robust low complexity audio watermarking system.

Background of the Invention

In many technical applications, it is desired to include an extra information into an information or signal representing useful data or "main data" like, for example, an audio signal, a video signal, graphics, a measurement quantity and so on. In many cases, it is desired to include the extra information such that the extra information is bound to the main data (for example, audio data, video data, still image data, measurement data, text data, and so on) in a way that it is not perceivable by a user of said data. Also, in some cases it is desirable to include the extra data such that the extra data are not easily removable from the main data (e.g. audio data, video data, still image data, measurement data, and so on).

This is particularly true in applications in which it is desirable to implement a digital rights management. However, it is sometimes simply desired to add substantially unperceivable side information to the useful data. For example, in some cases it is desirable to add side information to audio data, such that the side information provides an information about the source of the audio data, the content of the audio data, rights related to the audio data and so on.

For embedding extra data into useful data or "main data", a concept called "watermarking" may be used. Watermarking concepts have been discussed in the literature for many different kinds of useful data, like audio data, still image data, video data, text data, and so on.

In the following, some references will be given in which watermarking concepts are discussed. However, the reader's attention is also drawn to the wide field of textbook literature and publications related to the watermarking for further details.

DE 196 40 814 C2 describes a coding method for introducing a non-audible data signal into an audio signal and a method for decoding a data signal, which is included in an audio signal in a non-audible form. The coding method for introducing a non-audible data signal into an audio signal comprises converting the audio signal into the spectral domain. The coding method also comprises determining the masking threshold of the audio signal and the provision of a pseudo noise signal. The coding method also comprises providing the data signal and multiplying the pseudo noise signal with the data signal, in order to obtain a frequency-spread data signal. The coding method also comprises weighting the spread data signal with the masking threshold and overlapping the audio signal and the weighted data signal.

In addition, WO 93/07689 describes a method and apparatus for automatically identifying a program broadcast by a radio station or by a television channel, or recorded on a medium, by adding an inaudible encoded message to the sound signal of the program, the message identifying the broadcasting channel or station, the program and/or the exact date. In an embodiment discussed in said document, the sound signal is transmitted via an analog-to-digital converter to a data processor enabling frequency components to be split up, and enabling the energy in some of the frequency components to be altered in a predetermined manner to form an encoded identification message. The output from the data processor is connected by a digital-to-analog converter to an audio output for broadcasting or recording the sound signal. In another embodiment discussed in said document, an analog bandpass is employed to separate a band of frequencies from the sound signal so that energy in the separated band may be thus altered to encode the sound signal.

US 5, 450,490 describes apparatus and methods for including a code having at least one code frequency component in an audio signal. The abilities of various frequency components in the audio signal to mask the code frequency component to human hearing are evaluated and based on these evaluations an amplitude is assigned to the code frequency component. Methods and apparatus for detecting a code in an encoded audio signal are also described. A code frequency component in the encoded audio signal is detected based on an expected code amplitude or on a noise amplitude within a range of audio frequencies including the frequency of the code component.

WO 94/11989 describes a method and apparatus for encoding/decoding broadcast or recorded segments and monitoring audience exposure thereto. Methods and apparatus for encoding and decoding information in broadcasts or recorded segment signals are described. In an embodiment described in the document, an audience monitoring system encodes identification information in the audio signal portion of a broadcast or a recorded segment using spread spectrum encoding. The monitoring device receives an acoustically reproduced version of the broadcast or recorded signal via a microphone, decodes the identification information from the audio signal portion despite significant ambient noise and stores this information, automatically providing a diary for the audience member, which is later uploaded to a centralized facility. A separate monitoring device decodes additional information from the broadcast signal, which is matched with the audience diary information at the central facility. This monitor may simultaneously send data to the centralized facility using a dial-up telephone line, and receives data from the centralized facility through a signal encoded using a spread spectrum technique and modulated with a broadcast signal from a third party.

WO 95/27349 describes apparatus and methods for including codes in audio signals and decoding. An apparatus and methods for including a code having at least one code frequency component in an audio signal are described. The abilities of various frequency components in the audio signal to mask the code frequency component to human hearing are evaluated, and based on these evaluations, an amplitude is assigned to the code frequency components. Methods and apparatus for detecting a code in an encoded audio signal are also described. A code frequency component in the encoded audio signal is detected based on an expected code amplitude or on a noise amplitude within a range of audio frequencies including the frequency of the code component.

KIROVSKI D ET AL: "Robust Covert communication over a Public Audio Channel using Spread Spectrum", LECTURE NOTES IN COMPUTER SCIENCE, Vol. 2137/2001, 1 January 2001 (2001-01-01), pages 354-368, XP002590801 describe a robust watermarking technique for embedding redundant spread-spectrum watermarks in an audio data stream.

However, in the known watermarking systems, bit error rates are sometimes unsatisfactory. Also, the decoding complexity is sometimes very high, for example if very long spreading sequences are used. In addition, some conventional systems are sensitive to distortions of the watermarked signal by narrow band sources of distortion and/or pulse-like sources of distortion.

In view of this situation, it is an object of the present invention to create a concept for encoding and decoding a bit with good transmission reliability.

## Summary of the Invention

This objective is achieved by a watermark generator according to claim 1, a watermark decoder according to claim 10 or claim 11, a method for providing a watermark signal in dependence on binary message data according to claim 15, a method for providing binary message data in dependence on a watermarked signal according to claim 16 and a computer program according to claim 17.

An embodiment according to the invention creates a watermark generator for providing a watermark signal in dependence on binary message data. The watermark generator comprises an information processor configured to provide, in dependence on a single message bit, a two-dimensional spread information representing the message bit in the form of a set of time-frequency-domain values. The watermark generator also comprises a watermark signal provider configured to provide the watermark signal on the basis of the two-dimensional spread information.

It is the key idea of the present invention that a reliability of the transmission of a bit of the binary message data in the form of a watermark signal can be significantly improved by spreading the single message bit in both time and frequency. Accordingly, a particularly high degree of redundancy is achieved. Also, a good robustness against typical sources of distortion degrading the watermark signal is obtained, because many typical sources of distortion are either narrow band or short term (pulse like). Thus, by providing a two-dimensional spread information representing a single message bit, the information of the single message bit is transmitted in a plurality of frequency bands, such that a narrow band distortion (such as a narrow band distortion signal or a transfer function null) typically does not prevent a correct detection of the bit, and the information describing the bit is also distributed over a plurality of time intervals, such that a short click-type (pulse-like) distortion, which affects only one time interval or only a small number of time intervals (significantly smaller than the number of time intervals across which the single bit information is spread) typically does not eliminate the chance to recover the message bit with good reliability.

To summarize, the described concept provides an increased reliability to correctly receive a single bit of the binary message data at the side of a watermark decoder.

In a preferred embodiment, the information processor is configured to spread the message bit in a first spreading direction using a first spread sequence, in order to obtain an intermediate information representation, to combine the intermediate information representation with an overlay information representation, in order to obtain a combined information representation, and to spread the combined information representation in a second direction using a second spread sequence, in order to obtain the two-dimensional spread information. The usage of this mixed concept, in which separate spread sequences are used for the spreading of the message bit and the overlay information (for example a synchronization information) in the frequency direction, and in which a common spread sequence is used for the spreading in the time direction facilitates the coding while still maintaining the possibility to properly separate the message bit and the overlap information (e.g. the synchronization information). According to this concept, particularly reliable acquisition of a synchronization can be obtained, if the overlay information is a synchronization information. In this case, it is particularly advantageous that both the binary message data and the synchronization information are encoded using a common time spread sequence, because the time despreading must be executed at the decoder for a plurality of positional choices in order to acquire the synchronization. By using the same time spread sequence for the binary message data and the synchronization information, which is an example of an overlay information, the computational effort can be reduced and the synchronization can be facilitated.

In a preferred embodiment, the information processor is configured to combine the intermediate information representation with an overlay information representation, which is spread in the first spreading direction using an overlay information spreading sequence, such that the message bit and the overlay information are spread with different spreading sequences in the first spreading direction, and such that the combination of the message bit and the overlay information is spread with a common spreading sequence in the second spreading direction.

In a preferred embodiment, the information processor is configured to multiplicatively combine the intermediate information representation with the overlay information representation, and to spread the combined information representation, which comprises product values formed in dependence on values of the intermediate information representation and values of the overlap information, in the second spreading direction using the second spreading sequence, such that the product values are spread using a common spread sequence. A multiplicative combination of the intermediate information representation and the overlay information representation is particularly advantageous, because such a combination results in a data-independent energy of the values of the combined information representation, if magnitudes or absolute values of the elements of the intermediate information representation and/or the overlay information representation are independent on the binary message data. This facilitates an inaudible embedding of the combined information representation into a useful signal, for example an audio signal. Also, the application of the common spread sequence to the product values allows for a simple decoding, as discussed below.

In a preferred embodiment, the information processor is configured to selectively spread a given message bit onto a first bit representation, which is a positive multiple of a bit spread sequence, or onto a second bit representation, which is a negative multiple of the bit spread sequence, in dependence on the value of the given bit, in order to spread the message bit in the first spreading direction. By spreading different values of the given message bit onto linearly dependent spreading sequences, the decoding can be facilitated, because a single correlation will be sufficient.

In a preferred embodiment, the information processor is configured to map a given value of an intermediate information representation, which is obtained by spreading the message bit in the first direction, or a given value of a combined information representation, which is obtained by spreading the message bit in the first spreading direction and combining the result thereof with an overlay information representation, onto a set of spread values, such that the set of spread values is a scaled version of a second spread sequence, scaled in accordance with the given value. By using such a spreading in the second spreading direction, the spreading pattern can be obtained with very low complexity and minimum computational effort. The spreading in the first spreading direction and the spreading in the second spreading direction are performed substantially independently in this case, such that the spreader at the encoder side can have a simple structure and such that the despreader at the decoder side can be constructed in a very simple way also. In particular, a separate spreading in the time direction and the frequency direction can be performed at the encoder side, which reduces computational complexity significantly, and which allows the introduction of overlay information. At the decoder side, it is not necessary to correlate the time-frequency-domain representation of the watermarked signal with a full two-dimensional pattern. Rather, it is sufficient to perform correlation in the time direction and the frequency direction in separate steps.

An embodiment according to the invention creates a watermark decoder for providing binary message data in dependence on a watermarked signal. The watermark decoder comprises a time-frequency-domain representation provider configured to provide a time-frequency-domain representation of the watermarked signal, and a synchronization determinator comprising a despreader. The despreader comprises one or more despreader blocks, and the despreader is configured to perform a two-dimensional despreading in order to obtain a synchronization information in dependence on a two-dimensional portion of the time-frequency-domain representation. The watermark decoder also comprises a watermark extractor configured to extract the binary message data from the time-frequency-domain representation of the watermark signal using the synchronization information.

Yet another embodiment according to the invention creates a watermark decoder for providing binary message data in dependence on a watermarked signal. The watermark decoder comprises a time-frequency-domain representation provider configured to provide a time-frequency-domain representation of the watermarked signal and a watermark extractor comprising a despreader having one or more despreader blocks. The despreader is configured to perform a two-dimensional despreading in order to obtain a bit of the binary message data in dependence on a two-dimensional portion of the time-frequency-domain representation.

The latter two embodiments according to the invention are based on the finding that both the synchronization and a bit of binary message data can be acquired with good precision and reliability by performing a two-dimensional despreading. Accordingly, the watermark decoders allow for a realization of the advantages discussed above with respect to the watermark generator.

In a preferred embodiment, the despreader is configured to multiply a plurality of values of the time-frequency-domain representation with values of a temporal despread sequence and to add the results of the multiplications in order to obtain a temporally despread value. The despreader is configured to multiply a plurality of temporally despread values associated with different frequencies of the time-frequency-domain representations, or values derived therefrom, with a frequency despread sequence in an element-wise manner and to add results of the multiplication in order to obtain a two-dimensionally despread value. This embodiment implements a particularly simple and easy-to-implement despreading concept, in which a temporal despreading is performed independently from a frequency despreading. Accordingly, the watermark decoder can have a relatively simple  hardware structure, in which many components may for example be reused, while still providing good performance and high reliability.

In a preferred embodiment, the despreader is configured to obtain a set of temporally despread values. The despreader is configured to multiply a plurality of values of the time-frequency-domain representation with values of a temporal despread sequence, and to add results of the multiplication in order to obtain one of the temporally despread values. The despreader is also configured to multiply the temporally despread values with values of a frequency despread sequence in an element-wise manner, and to add results of the multiplications to obtain a two-dimensionally despread value.

In a preferred embodiment, the despreader is configured to multiply subsequent sets of temporally despread values with values of different frequency despread sequences in an element-wise manner, such that a first set of the temporally despread values effectively multiplied in an element-wise manner and in a 1-step or multi-step multiplication, with a first combined frequency despread sequence, which is a product of a common frequency despread sequence and a first overlay despread sequence, and such that a second set of the temporally despread values is effectively multiplied, in an element-wise manner and in a 1-step or a multi-step multiplication, with a second combined frequency despread sequence, which is a product of the common frequency despread sequence and a second overlay despread sequence, which is different from the first overlay frequency despread sequence. Using this concept, an alignment of bits can be identified while keeping the extraction of the data contents reasonably simple. As one of the frequency despread sequences is variable, while the other frequency despread sequence is fixed, a number of possible combinations is kept small. On the other hand, by using different frequency despread sequences for different time portions, a temporal alignment may nevertheless be determined.

Further embodiments according to the invention create a method for providing a watermark signal in dependence on binary message data and a method for providing binary message data in dependence on a watermarked signal. Also, some embodiments create a computer program for performing one or both of said methods. The methods and the computer program are based on the same findings as the above apparatus, such that the above explanations also hold.

Brief Description of the Figures

Embodiments according to the invention will subsequently be described taking reference to the enclosed figures, in which:

Fig. 1          shows a block schematic diagram of a watermark inserter according to an embodiment of the invention;

Fig. 2          shows a block-schematic diagram of a watermark decoder, according to an embodiment of the invention;

Fig. 3          shows a detailed block-schematic diagram of a watermark generator, according to an embodiment of the invention;

Fig. 4          shows a detailed block-schematic diagram of a modulator, for use in an embodiment of the invention;

Fig. 5          shows a detailed block-schematic diagram of a psychoacoustical processing module, for use in an embodiment of the invention;

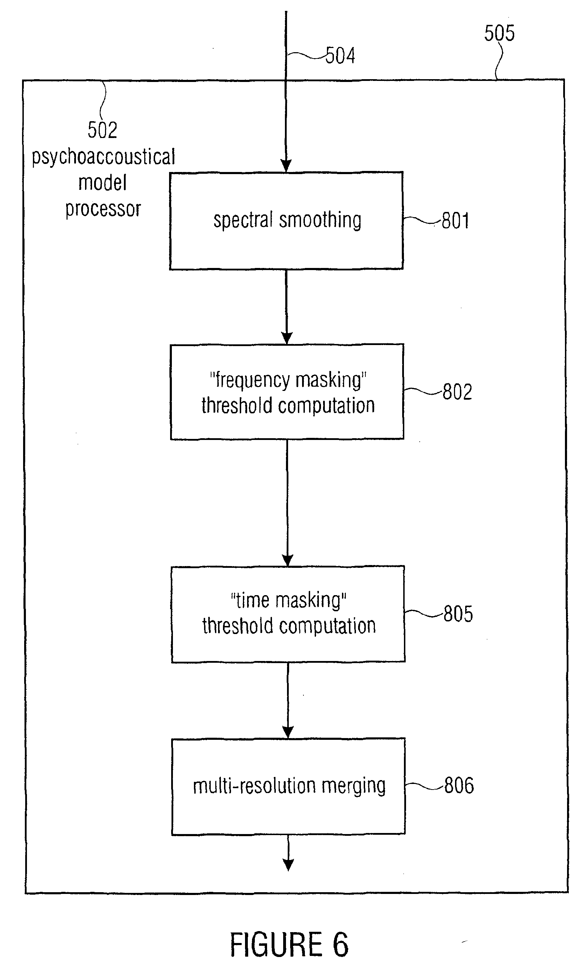

Fig. 6          shows a block-schematic diagram of a psychoacoustical model processor, for use in an embodiment of the invention;

Fig. 7          shows a graphical representation of a power spectrum of an audio signal output by block 801 over frequency;

| | |
|---|---|
| Fig. 8 | shows a graphical representation of a power spectrum of an audio signal output by block 802 over frequency; |
| Fig. 9 | shows a block-schematic diagram of an amplitude calculation; |
| Fig. 10a | shows a block schematic diagram of a modulator; |
| Fig. 10b | shows a graphical representation of the location of coefficients on the time-frequency claim; |
| Figs. 11a and 11b | show a block-schematic diagrams of implementation alternatives of the synchronization module; |
| Fig. 12a | shows a graphical representation of the problem of finding the temporal alignment of a watermark; |
| Fig. 12b | shows a graphical representation of the problem of identifying the message start; |
| Fig. 12c | shows a graphical representation of a temporal alignment of synchronization sequences in a full message synchronization mode; |
| Fig.12d | shows a graphical representation of the temporal alignment of the synchronization sequences in a partial message synchronization mode; |
| Fig. 12e | shows a graphical representation of input data of the synchronization module; |
| Fig.12f | shows a graphical representation of a concept of identifying a synchronization hit; |
| Fig. 12g | shows a block-schematic diagram of a synchronization signature correlator; |
| Fig. 13a | shows a graphical representation of an example for a temporal despreading; |
| Fig. 13b | shows a graphical representation of an example for an element-wise multiplication between bits and spreading sequences; |
| Fig. 13c | shows a graphical representation of an output of the synchronization signature correlator after temporal averaging; |
| Fig. 13d | shows a graphical representation of an output of the synchronization signature correlator filtered with the auto-correlation function of the synchronization signature; |
| Fig. 14 | shows a block-schematic diagram of a watermark extractor, according to an embodiment of the invention; |
| Fig. 15 | shows a schematic representation of a selection of a part of the time-frequency-domain representation as a candidate message; |
| Fig. 16 | shows a block-schematic diagram of an analysis module; |
| Fig. 17a | shows a graphical representation of an output of a synchronization correlator; |
| Fig. 17b | shows a graphical representation of decoded messages; |
| Fig. 17c | shows a graphical representation of a synchronization position, which is extracted from a watermarked signal; |
| Fig. 18a | shows a graphical representation of a payload, a payload with a Viterbi termination sequence, a Viterbi-encoded payload and a repetition-coded version of the Viterbi-coded payload; |
| Fig. 18b | shows a graphical representation of subcarriers used for embedding a watermarked signal; |

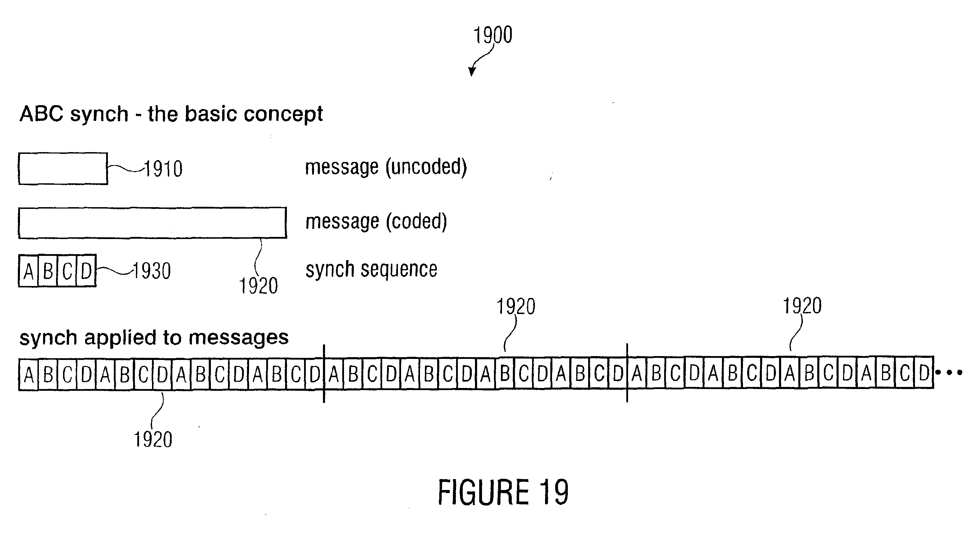

Fig. 19          shows a graphical representation of an uncoded message, a coded message, a synchronization message and a watermark signal, in which the synchronization sequence is applied to the messages;

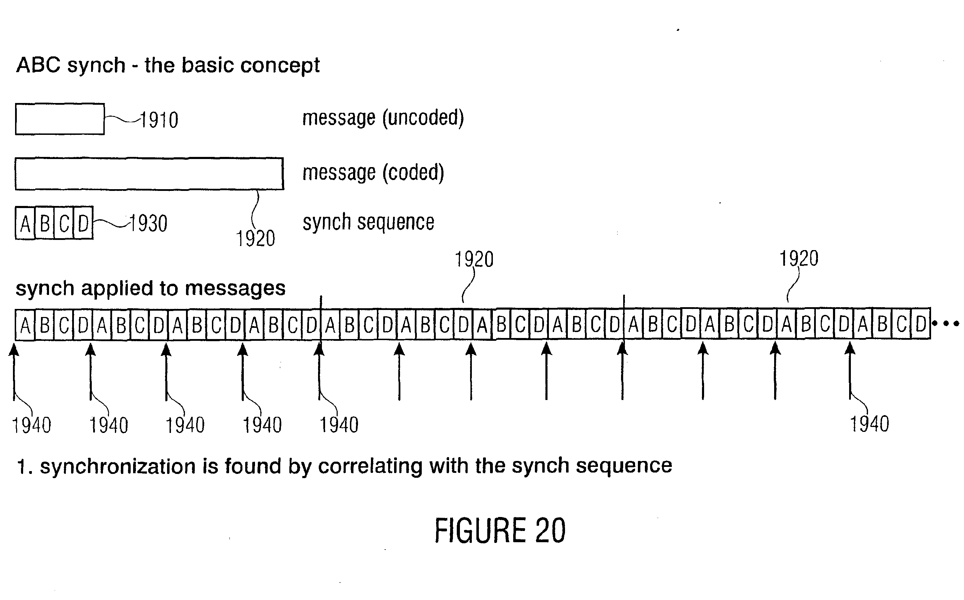

Fig. 20          shows a schematic representation of a first step of a so-called "ABC synchronization" concept;

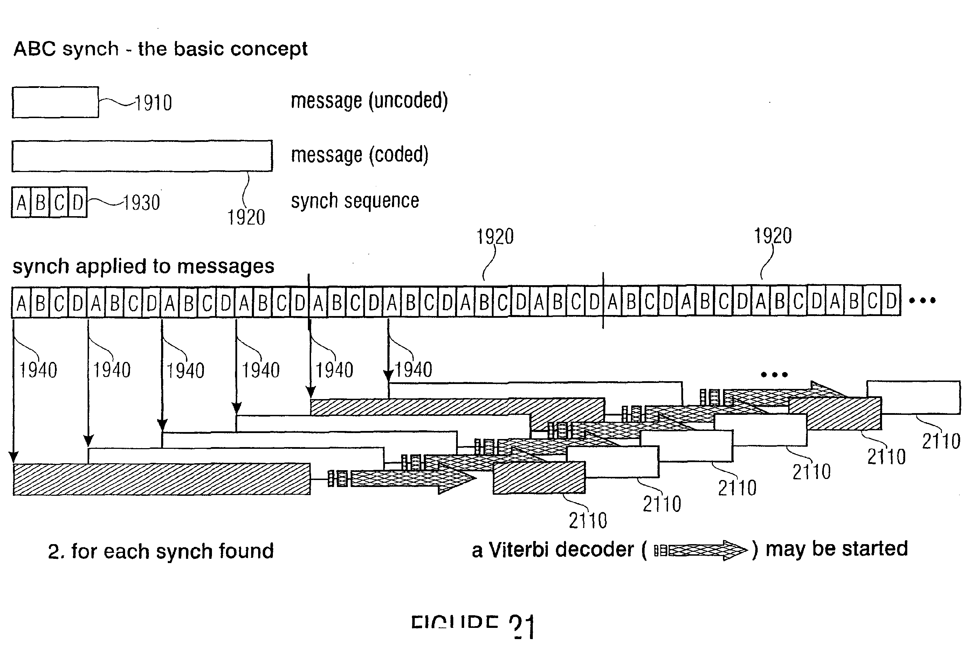

Fig. 21          shows a graphical representation of a second step of the so-called "ABC synchronization" concept;

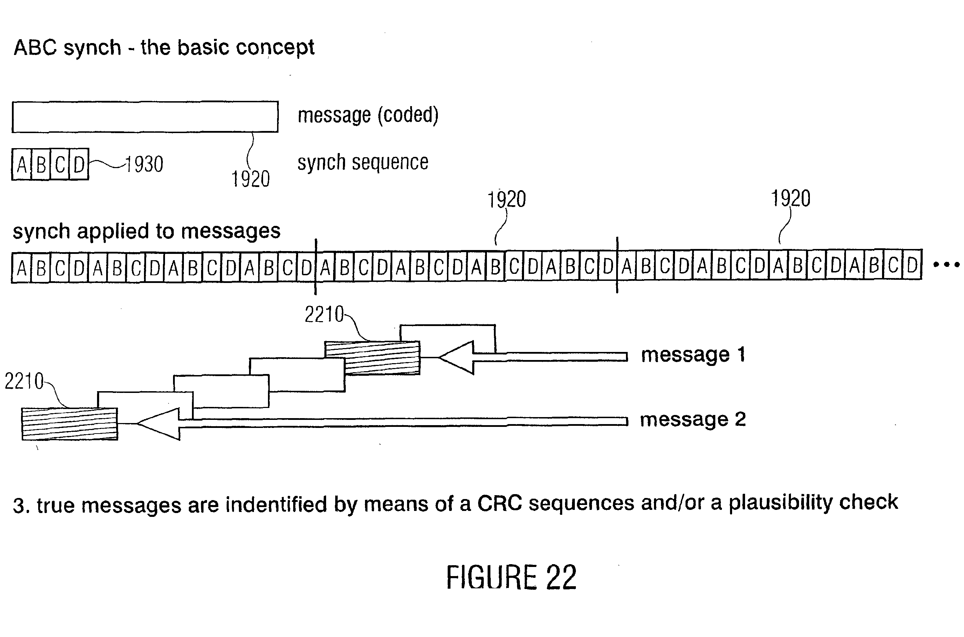

Fig. 22          shows a graphical representation of a third step of the so-called "ABC synchronization" concept;

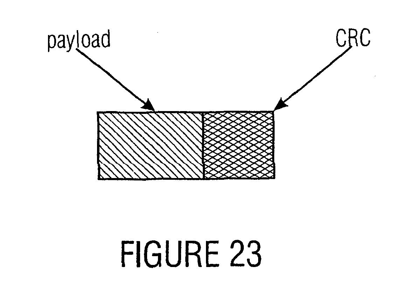

Fig. 23          shows a graphical representation of a message comprising a payload and a CRC portion;

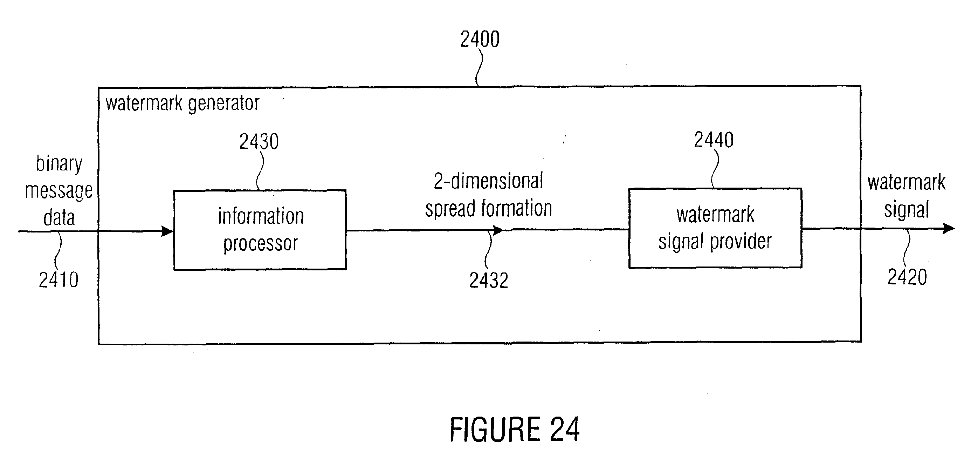

Fig. 24          shows a block-schematic diagram of a watermark generator, according to an embodiment of the invention;

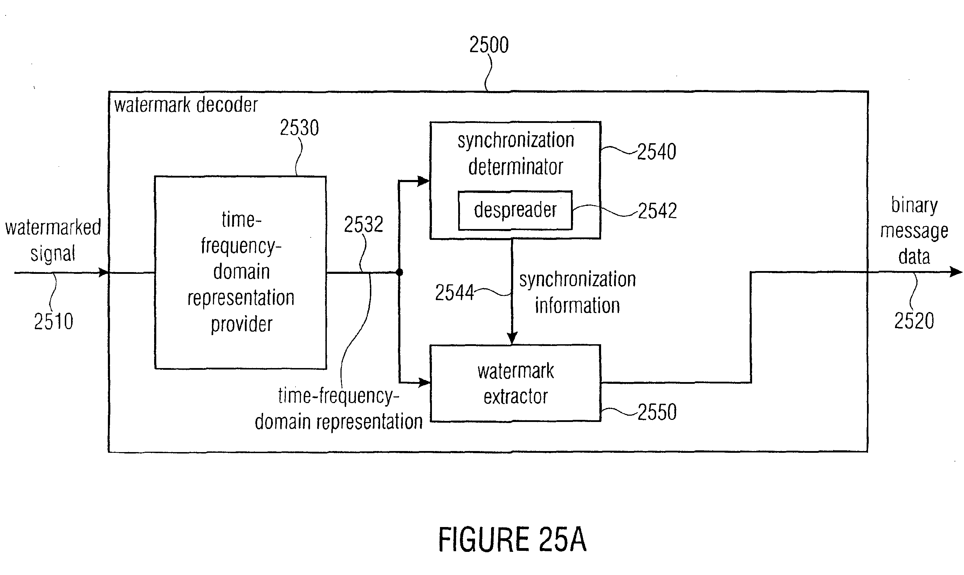

Fig. 25a          shows a block-schematic diagram of a watermark decoder, according to an embodiment of the invention;

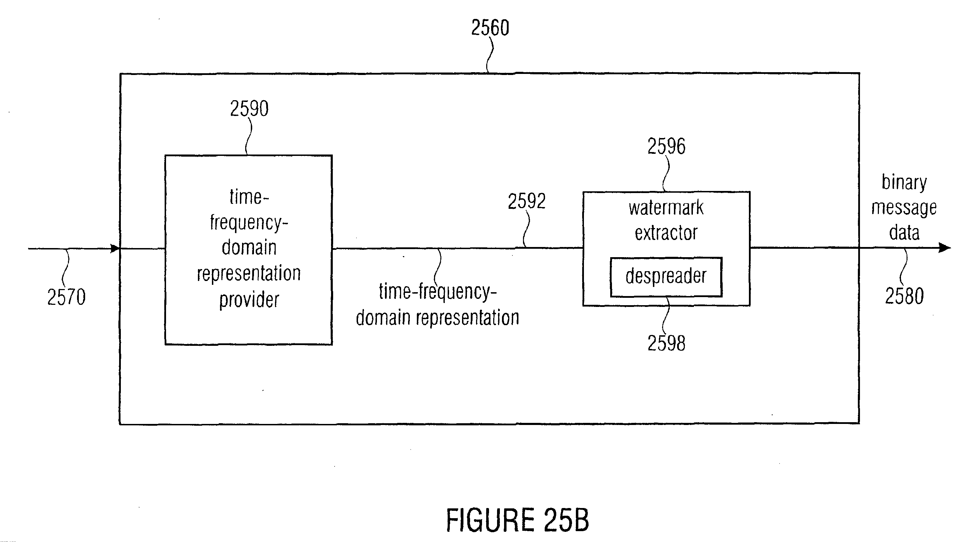

Fig. 25b          shows a block-schematic diagram of a watermark decoder, according to an embodiment of the invention;

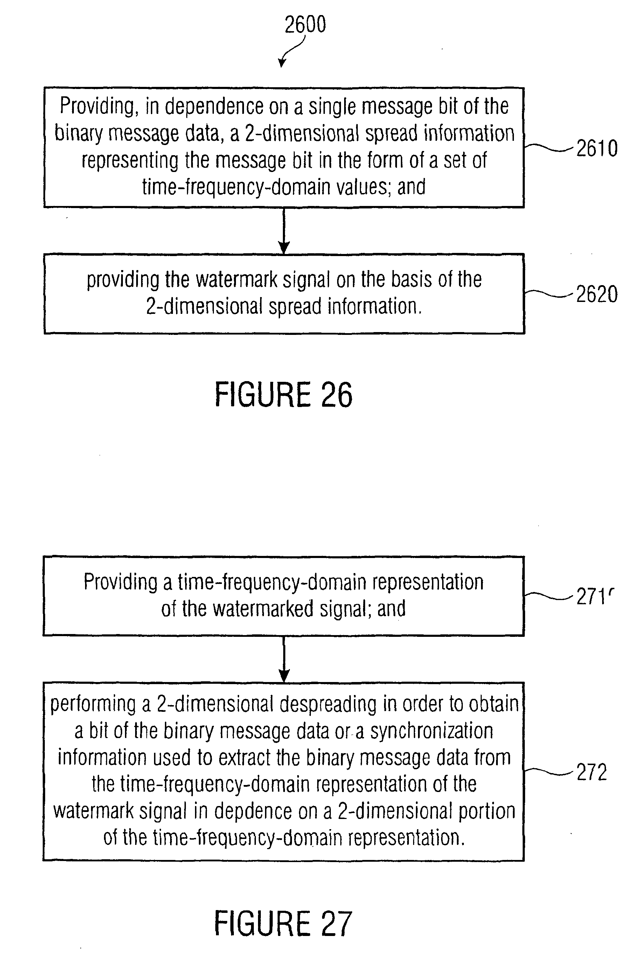

Fig. 26          shows a flowchart of a method for providing a watermark signal in dependence on binary message data; and

Fig. 27          shows a flowchart of a method for providing binary message data in dependence on a watermarked signal.

Detailed Description of the Embodiments

1. Watermark generation

1.1 Watermark generator according to Fig. 24

In the following, a watermark generator 2400 will be described taking reference to Fig. 24, which shows a block schematic diagram of such a watermark generator. The watermark generator 2400 is configured to receive binary message data 2410 and to provide, on the basis thereof, a watermark signal 2420. The watermark generator comprises an information processor 2430, which is configured to provide, in dependence on a single message bit of the binary message data 2410, a two-dimensional spread information 2432 representing the message bit in the form of a set of time-frequency-domain values. The watermark generator 2400 also comprises a watermark signal provider 2440, which is configured to provide the watermark signal 2420 on the basis of the two-dimensional spread information 2432.
The watermark generator 2400 may be supplemented by any of the features and functionalities which are discussed in more detail in section 3 below.

1.2 Method for providing a watermark signal in dependence on binary message data according to Fig. 26

In the following, a method for providing a watermark signal in dependence on binary message data will be explained taking reference to Fig. 26, which shows a flowchart of such a method.
The method 2600 of Fig. 26 comprises a step 2610 of providing, in dependence on a single message bit of the binary message data, a two-dimensional spread information representing the message bit in the form of a set of time-frequency-domain values. The method 2600 also comprises a step 2620 of providing the watermark signal on the basis of the two-dimensional spread information.
Naturally, the method 2600 can be supplemented by any of the features and functionalities discussed herein, also with respect to the inventive apparatus.

2. Watermark decoding

2.1 Watermark decoder according to Fig. 25a

In the following, a watermark decoder 2500 will be described taking reference to Fig. 25a, which shows a block schematic diagram of such a watermark decoder.

The watermark decoder 2500 is configured to provide binary message data 2520 in dependence on a watermarked signal 2510. The watermark decoder 2500 comprises a time-frequency-domain representation provider 2530 configured to provide a time-frequency-domain representation 2532 of the watermarked signal. The watermark decoder 2500 also comprises a synchronization determinator 2540. The synchronization determinator 2540 comprises a despreader 2542 having one or more despreader blocks. The despreader 2542 is configured to perform a two-dimensional despreading in order to obtain a synchronization information 2544 in dependence on a two-dimensional portion of the time-frequency-domain representation 2532. The watermark decoder 2500 also comprises a watermark extractor 2550 configured to extract the binary message data 2520 from the time-frequency-domain representation 2532 of the watermarked signal using the synchronization information 2544.

Naturally, the watermark decoder 2500 may be supplemented by any of the means and functionalities discussed here with respect to the watermark decoding.

2.2 Watermark decoder according to Fig. 25b

In the following, a watermark generator 2560 will be described taking reference to Fig. 25b, which shows a block schematic diagram of such a watermark generator.

The watermark generator 2560 is configured to receive a watermark signal 2570 and to provide, on the basis thereof, binary message data 2580. The watermark decoder 2560 comprises a time-frequency-domain representation provider 2590 configured to provide a time-frequency-domain representation 2592 of the watermark signal 2570. The watermark decoder also comprises a watermark extractor 2596 comprising a despreader 2598. The despreader is configured to perform a two-dimensional despreading in order to obtain a bit of the binary message data in dependence on a two-dimensional portion of the time-frequency-domain representation 2592.

Naturally, the watermark decoder 2560 can be supplemented by any of the means and functionalities discussed herein with respect to the watermark decoding.

2.2 Method for providing binary message data in dependence on a watermarked signal according to Fig. 27

In the following, a method 2700 for providing binary message data in dependence on a watermarked signal will be described taking reference to Fig. 27, which shows a flowchart of such a method.

The method 2700 comprises a step 2710 of providing a time-frequency-domain representation of the watermarked signal. The method 2700 also comprises a step 2720 of performing a two-dimensional despreading in order to obtain a bit of the binary message data or a synchronization information used to extract the binary message data from the time-frequency-domain representation of the watermarked signal in dependence on a two-dimensional portion of the time-frequency-domain representation.

Naturally, the method 2700 can be supplemented by any of the features and functionalities described herein with respect to the watermark decoding.

3. System Description

In the following, a system for a watermark transmission will be described, which comprises a watermark inserter and a watermark decoder. Naturally, the watermark inserter and the watermark decoder can be used independent from each other.

For the description of the system a top-down approach is chosen here. First, it is distinguished between encoder and decoder. Then, in sections 3.1 to 3.5 each processing block is described in detail.

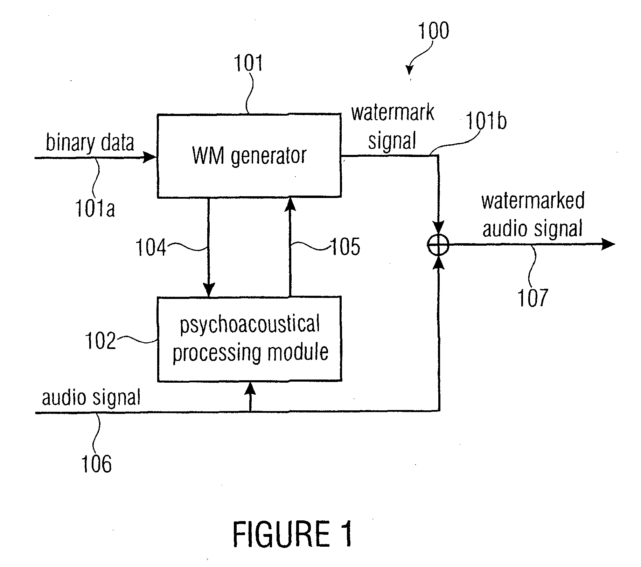

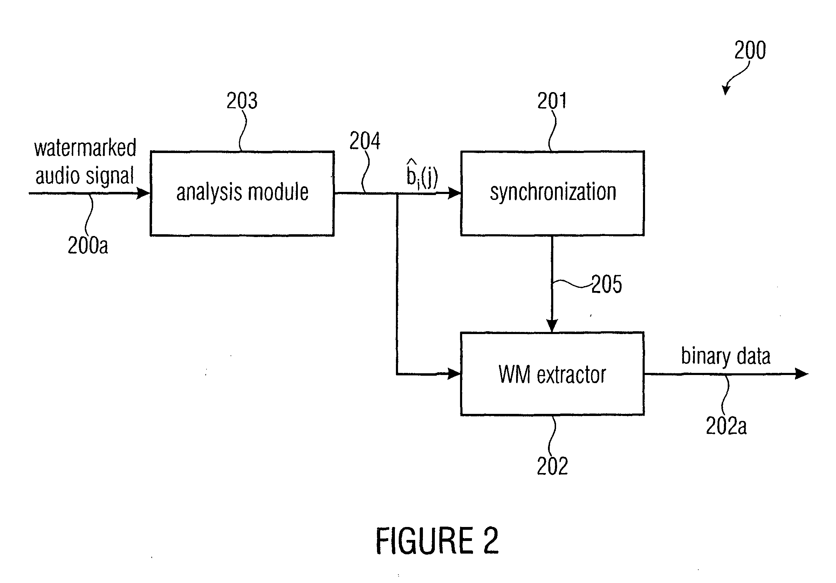

The basic structure of the system can be seen in Figures 1 and 2, which depict the encoder and decoder side, respectively. Fig 1 shows a block schematic diagram of a watermark inserter 100. At the encoder side, the watermark signal 101b is generated in the processing block 101 (also designated as watermark generator) from binary data 101a and on the basis of information 104, 105 exchanged with the psychoacoustical processing module 102. The information provided from block 102 typically guarantees that the watermark is inaudible. The watermark generated by the watermark generator 101 is then added to the audio signal 106. The watermarked signal 107 can then be transmitted, stored, or further processed. In case of a multimedia file, e.g., an audio-video file, a proper delay needs to be added to the video stream not to lose audio-video synchronicity. In case of a multichannel audio signal, each channel is processed separately as explained in this document. The processing blocks 101 (watermark generator) and 102 (psychoacoustical processing module) are explained in detail in Sections 3.1 and 3.2, respectively.

The decoder side is depicted in Figure 2, which shows a block schematic diagram of a watermark detector 200. A watermarked audio signal 200a, e.g., recorded by a microphone, is made available to the system 200. A first block 203, which is also designated as an analysis module, demodulates and transforms the data (e.g., the watermarked audio signal) in time/frequency domain (thereby obtaining a time-frequency-domain representation 204 of the watermarked audio signal 200a) passing it to the synchronization module 201, which analyzes the input signal 204 and carries out a temporal synchronization, namely, determines the temporal alignment of the encoded data (e.g. of the encoded watermark data relative to the time-frequency-domain representation). This information (e.g., the resulting synchronization information 205) is given to the watermark extractor 202, which decodes the data (and consequently provides the binary data 202a, which represent the data content of the watermarked audio signal 200a).

### 3.1 The Watermark Generator 101

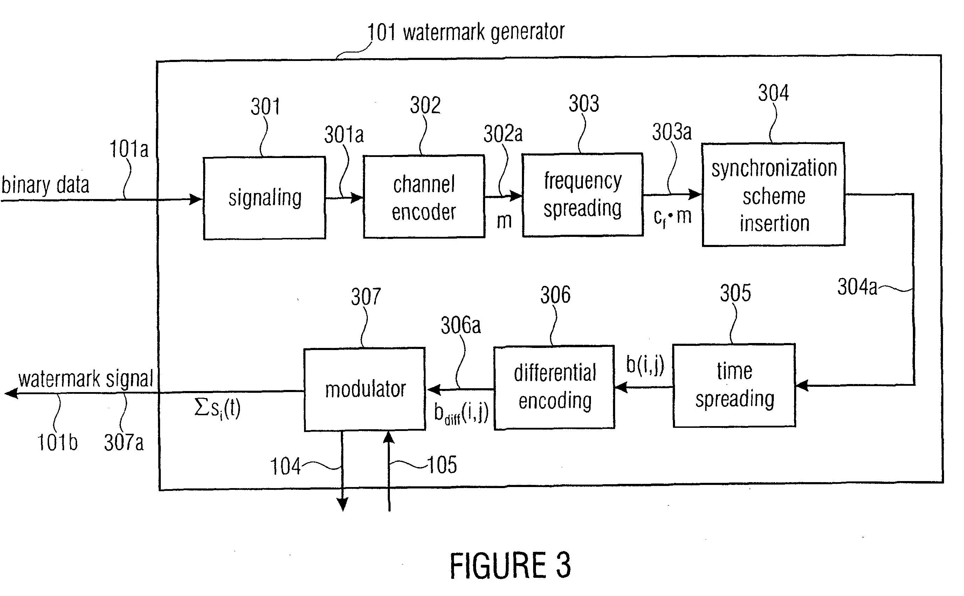

The watermark generator 101 is depicted detail in Figure 3. Binary data (expressed as $\pm 1$) to be hidden in the audio signal 106 is given to the watermark generator 101. The block 301 organizes the data 101a in packets of equal length $M_p$. Overhead bits are added (e.g. appended) for signaling purposes to each packet. Let $M_s$ denote their number. Their use will be explained in detail in Section 3.5. Note that in the following each packet of payload bits together with the signaling overhead bits is denoted message.

Each message 301a, of length $N_m = M_s + M_p$, is handed over to the processing block 302, the channel encoder, which is responsible of coding the bits for protection against errors. A possible embodiment of this module consists of a convolutional encoder together with an interleaver. The ratio of the convolutional encoder influences greatly the overall degree of protection against errors of the watermarking system. The interleaver, on the other hand, brings protection against noise bursts. The range of operation of the interleaver can be limited to one message but it could also be extended to more messages. Let $R_c$ denote the code ratio, e.g., 1/4. The number of coded bits for each message is $N_m/R_c$. The channel encoder provides, for example, an encoded binary message 302a.

The next processing block, 303, carries out a spreading in frequency domain. In order to achieve sufficient signal to noise ratio, the information (e.g. the information of the binary message 302a) is spread and transmitted in $N_f$ carefully chosen subbands. Their exact position in frequency is decided a priori and is known to both the encoder and the decoder. Details on the choice of this important system parameter is given in Section 3.2.2. The spreading in frequency is determined by the spreading sequence $c_f$ of size $N_f \times 1$. The output 303a of the block 303 consists of $N_f$ bit streams, one for each subband. The i-th bit stream is obtained by multiplying the input bit with the i-th component of spreading sequence cf. The simplest spreading consists of copying the bit stream to each output stream, namely use a spreading sequence of all ones.

Block 304, which is also designated as a synchronization scheme inserter, adds a synchronization signal to the bit stream. A robust synchronization is important as the decoder does not know the temporal alignment of neither bits nor the data structure, i.e., when each message starts. The synchronization signal consists of $N_s$ sequences of $N_f$ bits each. The sequences are multiplied element wise and periodically to the bit stream (or bit streams 303a). For instance, let **a, b,** and **c,** be the Ns = 3 synchronization sequences (also designated as synchronization spreading sequences). Block. 304 multiplies **a** to the first spread bit, **b** to the second spread bit, and **c** to the third spread bit. For the following bits the process is periodically iterated, namely, **a** to the fourth bit, **b** for the fifth bit and so on. Accordingly, a combined information-synchronization information 304a is obtained. The synchronization sequences (also designated as synchronization spread sequences) are carefully chosen to minimize the risk of a false synchronization. More details are given in Section 3.4. Also, it should be noted that a sequence **a, b, c,...** may be considered as a sequence of synchronization spread sequences.

Block 305 carries out a spreading in time domain. Each spread bit at the input, namely a vector of length $N_f$, is repeated in time domain $N_t$ times. Similarly to the spreading in frequency, we define a spreading sequence $c_t$ of size $N_t \times 1$. The i-th temporal repetition is multiplied with the i-th component of $c_t$.

The operations of blocks 302 to 305 can be put in mathematical terms as follows. Let **m** of size $1 \times N_m = R_c$ be a coded message, output of 302. The output 303a (which may be considered as a spread information representation **R**) of block 303 is

$$c_f \cdot m \quad \text{of size} \quad N_f \times N_m/R_c$$

$$(1)$$

the output 304a of block 304, which may be considered as a combined information-synchronization representation **C**, is

$$S \circ (c_{\mathrm{f}} \cdot m) \quad \text{of size} \quad N_{\mathrm{f}} \times N_{\mathrm{m}}/R_{\mathrm{c}}$$

$$(2)$$

where denotes the Schur element-wise product and

$$S = \begin{bmatrix} \ldots & a & b & c & \ldots & a & b & \ldots \end{bmatrix} \quad \text{of size} \quad N_{\mathrm{f}} \times N_{\mathrm{m}}/R_{\mathrm{c}}.$$

$$(3)$$

The output 305a of 305 is

$$(S \circ (c_{\mathrm{f}} \cdot m)) \diamond c_{\mathrm{t}}^{\mathrm{T}} \quad \text{of size} \quad N_{\mathrm{f}} \times N_{\mathrm{t}} \cdot N_{\mathrm{m}}/R_{\mathrm{c}}$$

$$(4)$$

where $\diamond$ and $^{\mathrm{T}}$ denote the Kronecker product and transpose, respectively. Please recall that binary data is expressed as $\pm 1$.

Block **306** performs a differential encoding of the bits. This step gives the system additional robustness against phase shifts due to movement or local oscillator mismatches. More details on this matter are given in Section 3.3. If b (i; j) is the bit for the i-th frequency band and j-th time block at the input of block 306, the output bit $b_{\mathrm{diff}}$ (i; j) is

$$b_{\mathrm{diff}}(i,j) = b_{\mathrm{diff}}(i,j-1) \cdot b(i,j).$$

$$(5)$$

At the beginning of the stream, that is for j = 0, $b_{\mathrm{diff}}$(i,j - 1) is set to 1.

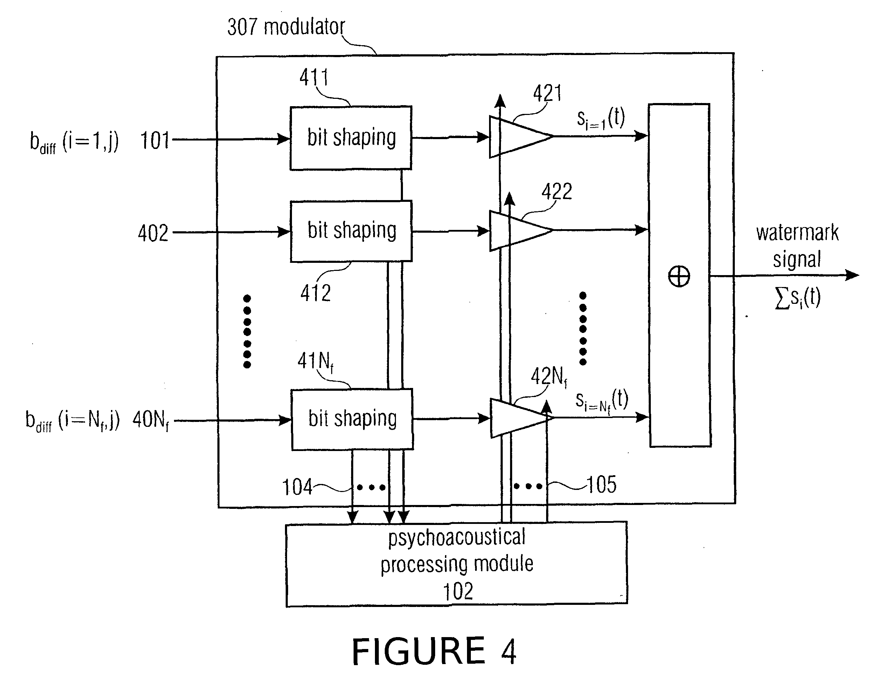

Block 307 carries out the actual modulation, i.e., the generation of the watermark signal waveform depending on the binary information 306a given at its input. A more detailed schematics is given in Figure 4. $N_{\mathrm{f}}$ parallel inputs, 401 to 40$N_{\mathrm{f}}$ contain the bit streams for the different subbands. Each bit of each subband stream is processed by a bit shaping block (411 to 41$N_{\mathrm{f}}$). The output of the bit shaping blocks are waveforms in time domain. The waveform generated for the j-th time block and i-th subband, denoted by $s_{i;j}$(t), on the basis of the input bit $b_{\mathrm{diff}}$(i, j) is computed as follows

$$s_{i,j}(t) = b_{\mathrm{diff}}(i,j)\gamma(i,j) \cdot g_i(t - j \cdot T_{\mathrm{b}}),$$

$$(6)$$

where $\gamma$(i; j) is a weighting factor provided by the psychoacoustical processing unit 102, $T_{\mathrm{b}}$ is the bit time interval, and $g_i$(t) is the bit forming function for the i-th subband. The bit forming function is obtained from a baseband function modulated in frequency with a cosine

$$g_i(t) = g_i^{\mathrm{T}}(t) \cdot \cos(2\pi f_i t)$$

$$(7)$$

where $f_i$ is the center frequency of the i-th subband and the superscript T stands for transmitter. The baseband functions can be different for each subband. If chosen identical, a more efficient implementation at the decoder is possible. See Section 3.3 for more details.

The bit shaping for each bit is repeated in an iterative process controlled by the psychoacoustical processing module (102). Iterations are necessary to fine tune the weights $\gamma(i, j)$ to assign as much energy as possible to the watermark while keeping it inaudible. More details are given in Section 3.2.

The complete waveform at the output of the i-th bit shaping fillter 41i is

$$s_i(t) = \sum_j s_{i,j}(t).$$

$$(8)$$

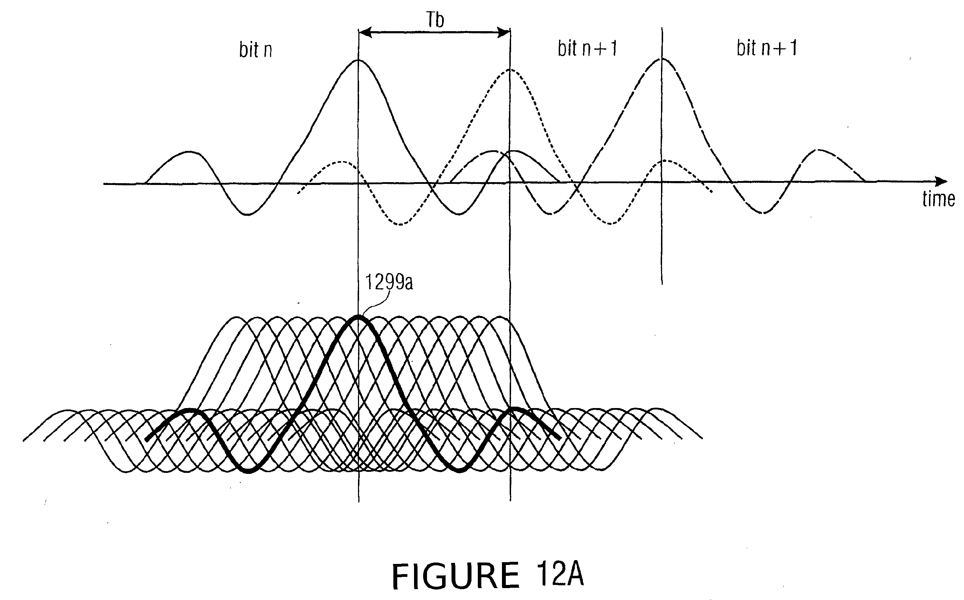

The bit forming baseband function is normally non zero for a time interval much larger than $T_b$, although the main energy is concentrated within the bit interval. An example can be seen if Figure 12a where the same bit forming baseband function is plotted for two adjacent bits. In the figure we have $T_b$ = 40 ms. The choice of $T_b$ as well as the shape of the function affect the system considerably. In fact, longer symbols provide narrower frequency responses. This is particularly beneficial in reverberant environments. In fact, in such scenarios the watermarked signal reaches the microphone via several propagation paths, each characterized by a different propagation time. The resulting channel exhibits strong frequency selectivity. Interpreted in time domain, longer symbols are beneficial as echoes with a delay comparable to the bit interval yield constructive interference, meaning that they increase the received signal energy. Notwithstanding, longer symbols bring also a few drawbacks; larger overlaps might lead to intersymbol interference (ISI) and are for sure more difficult to hide in the audio signal, so that the psychoacoustical processing module would allow less energy than for shorter symbols.

The watermark signal is obtained by summing all outputs of the bit shaping filters

$$\sum_i s_i(t).$$

$$(9)$$

### 3.2 The Psychoacoustical Processing Module 102

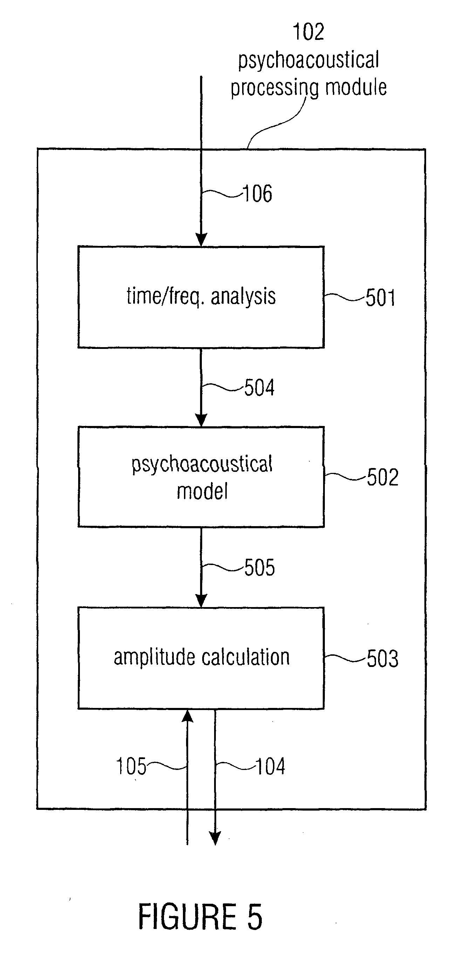

As depicted in Figure 5, the psychoacoustical processing module 102 consists of 3 parts. The first step is an analysis module **501** which transforms the time audio signal into the time/frequency domain. This analysis module may carry out parallel analyses in different time/frequency resolutions. After the analysis module, the time/frequency data is transferred to the psychoacoustic model (PAM) **502,** in which masking thresholds for the watermark signal are calculated according to psychoacoustical considerations (see E. Zwicker H.Fastl, "Psychoacoustics Facts and models"). The masking thresholds indicate the amount of energy which can be hidden in the audio signal for each subband and time block. The last block in the psychoacoustical processing module 102 depicts the amplitude calculation module **503**. This module determines the amplitude gains to be used in the generation of the watermark signal so that the masking thresholds are satisfied, i.e., the embedded energy is less or equal to the energy defined by the masking thresholds.

### 3.2.1 The Time/Frequency Analysis 501

Block **501** carries out the time/frequency transformation of the audio signal by means of a lapped transform. The best audio quality can be achieved when multiple time/frequency resolutions are performed. One efficient embodiment of a lapped transform is the short time Fourier transform (STFT), which is based on fast Fourier transforms (FFT) of windowed time blocks. The length of the window determines the time/frequency resolution, so that longer windows yield lower time and higher frequency resolutions, while shorter windows vice versa. The shape of the window, on the other hand, among other things, determines the frequency leakage.

For the proposed system, we achieve an inaudible watermark by analyzing the data with two different resolutions. A first filter bank is characterized by a hop size of $T_b$, i.e., the bit length. The hop size is the time interval between two adjacent time blocks. The window length is approximately $T_b$. Please note that the window shape does not have to be the same as the one used for the bit shaping, and in general should model the human hearing system. Numerous publications study this problem.

The second filter bank applies a shorter window. The higher temporal resolution achieved is particularly important when embedding a watermark in speech, as its temporal structure is in general finer than $T_b$.

The sampling rate of the input audio signal is not important, as long as it is large enough to describe the watermark signal without aliasing. For instance, if the largest frequency component contained in the watermark signal is 6 kHz, then the sampling rate of the time signals must be at least 12 kHz.

### 3.2.2 The Psychoacoustical Model 502

The psychoacoustical model 502 has the task to determine the masking thresholds, i.e., the amount of energy which can be hidden in the audio signal for each subband and time block keeping the watermarked audio signal indistinguishable from the original.

The i-th subband is defined between two limits, namely $f_i^{(min)}$ and $f_i^{(max)}$. The subbands are determined by defining $N_f$ center frequencies $f_i$ and letting $f_{i-1}^{(max)} = f_i^{(min)}$ for i = 2, 3, ... , $N_f$. An appropriate choice for the center frequencies is given by the Bark scale proposed by Zwicker in 1961. The subbands become larger for higher center frequencies. A possible implementation of the system uses 9 subbands ranging from 1.5 to 6 kHz arranged in an appropriate way.

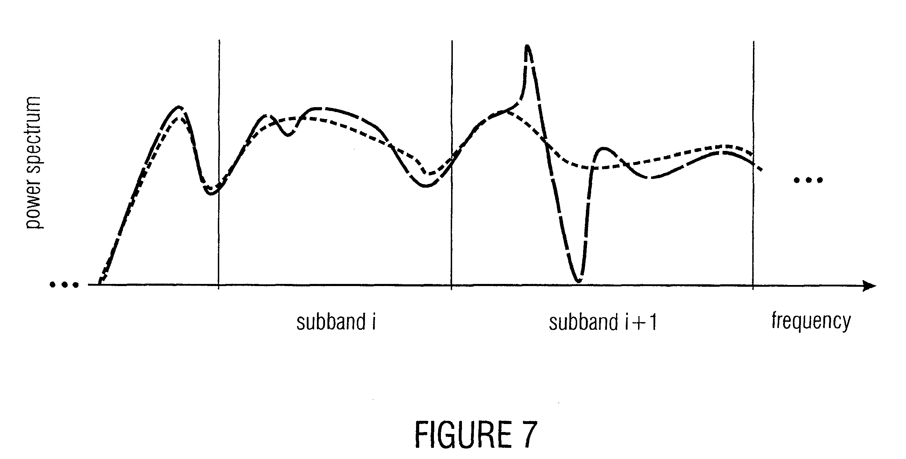

The following processing steps are carried out separately for each time/frequency resolution for each subband and each time block. The processing step **801** carries out a spectral smoothing. In fact, tonal elements, as well as notches in the power spectrum need to be smoothed. This can be carried out in several ways. A tonality measure may be computed and then used to drive an adaptive smoothing filter. Alternatively, in a simpler implementation of this block, a median-like filter can be used. The median filter considers a vector of values and outputs their median value. In a median-like filter the value corresponding to a different quantile than 50% can be chosen. The filter width is defined in Hz and is applied as a non-linear moving average which starts at the lower frequencies and ends up at the highest possible frequency. The operation of **801** is illustrated in Figure 7. The red curve is the output of the smoothing.

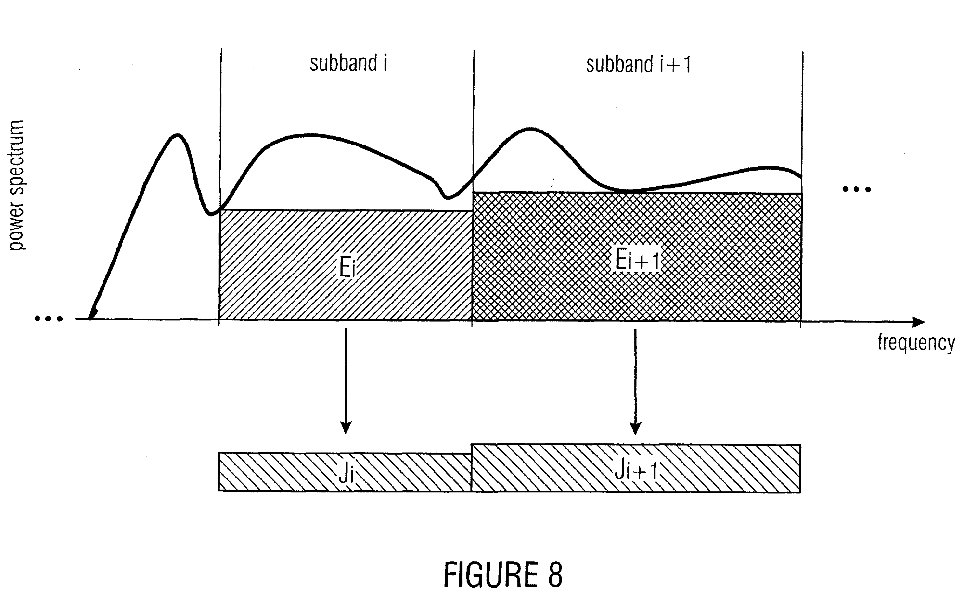

Once the smoothing has been carried out, the thresholds are computed by block **802** considering only frequency masking. Also in this case there are different possibilities. One way is to use the minimum for each subband to compute the masking energy $E_i$. This is the equivalent energy of the signal which effectively operates a masking. From this value we can simply multiply a certain scaling factor to obtain the masked energy $J_i$. These factors are different for each subband and time/frequency resolution and are obtained via empirical psychoacoustical experiments. These steps are illustrated in Figure 8.

In block **805**, temporal masking is considered. In this case, different time blocks for the same subband are analyzed. The masked energies $J_i$ are modified according to an empirically derived postmasking profile. Let us consider two adjacent time blocks, namely k-1 and k. The corresponding masked energies are $J_i(k-1)$ and $J_i(k)$. The postmasking profile defines that, e.g., the masking energy $E_i$ can mask an energy $J_i$ at time k and $\alpha \cdot J_i$ at time k+1. In this case, block **805** compares $J_i(k)$ (the energy masked by the current time block) and $\alpha \cdot J_i(k+1)$ (the energy masked by the previous time block) and chooses the maximum. Postmasking profiles are available in the literature and have been obtained via empirical psychoacoustical experiments. Note that for large $T_b$, i.e., > 20 ms, postmasking is applied only to the time/frequency resolution with shorter time windows.

Summarizing, at the output of block **805** we have the masking thresholds per each subband and time block obtained for two different time/frequency resolutions. The thresholds have been obtained by considering both frequency and time masking phenomena. In block **806,** the thresholds for the different time/frequency resolutions are merged. For instance, a possible implementation is that **806** considers all thresholds corresponding to the time and frequency intervals in which a bit is allocated, and chooses the minimum.

### 3.2.3 The Amplitude Calculation Block 503

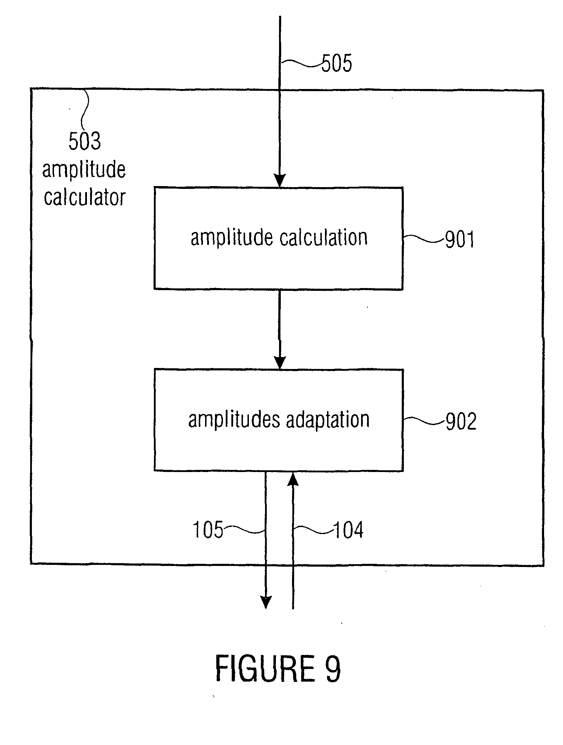

Please refer to Figure 9. The input of 503 are the thresholds 505 from the psychoacoustical model 502 where all psychoacoustics motivated calculations are carried out. In the amplitude calculator 503 additional computations with the thresholds are performed. First, an amplitude mapping **901** takes place. This block merely converts the masking thresholds (normally expressed as energies) into amplitudes which can be used to scale the bit shaping function defined in Section 3.1. Afterwards, the amplitude adaptation block **902** is run. This block iteratively adapts the amplitudes $\gamma(i, j)$ which are used to multiply the bit shaping functions in the watermark generator 101 so that the masking thresholds are indeed fulfilled. In fact, as already discussed, the bit shaping function normally extends for a time interval larger than $T_b$. Therefore, multiplying the correct amplitude $\gamma(i, j)$ which fulfills the masking threshold at point i, j does not necessarily fulfill the requirements at point i, j-1. This is particularly crucial at strong onsets, as a preecho becomes audible. Another situation which needs to be avoided is the unfortunate superposition of the tails of different bits which might lead to an audible watermark. Therefore, block 902 analyzes the signal generated by the watermark generator to check whether the thresholds have been fulfilled. If not, it modifies the amplitudes $\gamma(i,j)$ accordingly.

This concludes the encoder side. The following sections deal with the processing steps carried out at the receiver (also designated as watermark decoder).

### 3.3 The Analysis Module 203

The analysis module 203 is the first step (or block) of the watermark extraction process. Its purpose is to transform the watermarked audio signal 200a back into $N_f$ bit streams $\hat{b}_i(j)$ (also designated with 204), one for each spectral subband i. These are further processed by the synchronization module 201 and the watermark extractor 202, as discussed in Sections 3.4 and 3.5, respectively. Note that the $\hat{b}_i(j)$ are soft bit streams, i.e., they can take, for example, any real value and no hard decision on the bit is made yet.

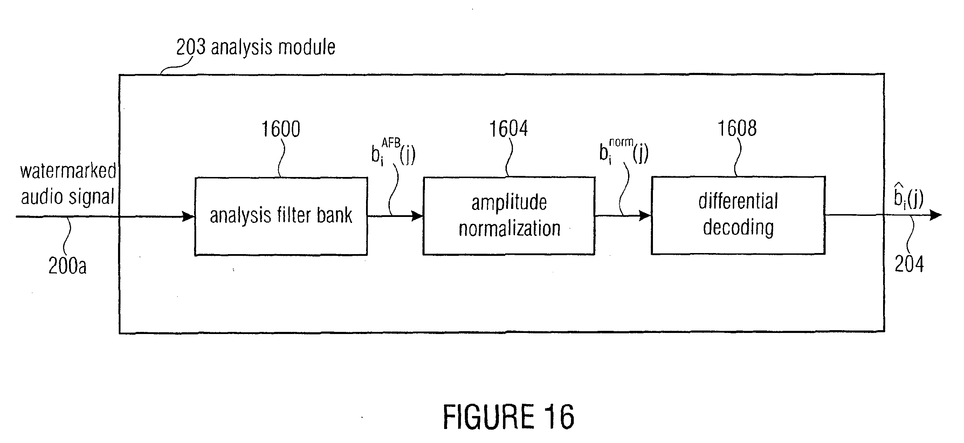

The analysis module consists of three parts which are depicted in Figure 16: The analysis filter bank 1600, the amplitude normalization block 1604 and the differential decoding 1608.

### 3.3.1 Analysis filter bank 1600

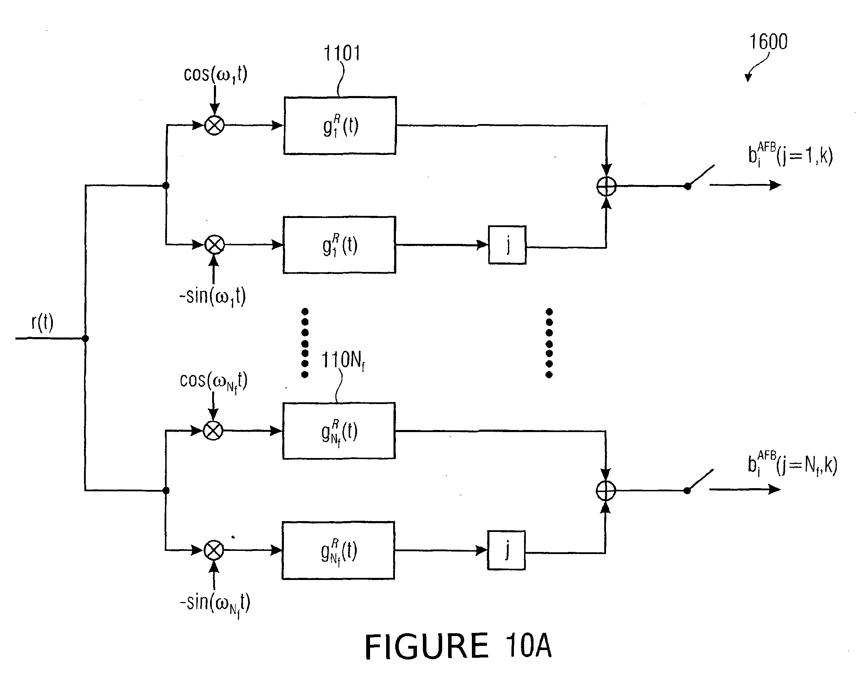

The watermarked audio signal is transformed into the time-frequency domain by the analysis filter bank 1600 which is shown in detail in Figure 10a. The input of the filter bank is the received watermarked audio signal r(t). Its output are the complex coefficients $b_i^{AFB}(j)$ for the i-th branch or subband at time instant j. These values contain information about the amplitude and the phase of the signal at center frequency $f_i$ and time j·Tb.

The filter bank 1600 consists of $N_f$ branches, one for each spectral subband i. Each branch splits up into an upper subbranch for the in-phase component and a lower subbranch for the quadrature component of the subband i. Although the modulation at the watermark generator and thus the watermarked audio signal are purely real-valued, the complex-valued analysis of the signal at the receiver is needed because rotations of the modulation constellation introduced by the channel and by synchronization misalignments are not known at the receiver. In the following we consider the i-th branch of the filter bank. By combining the in-phase and the quadrature subbranch, we can define the complex-valued baseband signal $b_i^{\hat{A}FB}(t)$ as

$$ b_i^{\mathrm{AFB}}(t) = r(t) \cdot e^{-j2\pi f_i t} * g_i^{\mathrm{R}}(t) $$

$$ (10) $$

where * indicates convolution and $g_i^{\mathrm{R}}(t)$ is the impulse response of the receiver lowpass filter of subband i. Usually $g_i^{\mathrm{R}}(t)_{\mathbf{i}}$ (t) is equal to the baseband bit forming function $g_i^{T}(t)_{\mathbf{i}}$ of subband i in the modulator 307 in order to fulfill the matched filter condition, but other impulse responses are possible as well.

In order to obtain the coefficients $b_i^{\mathrm{AFB}}(j)$ with rate 1=$T_b$, the continuous output $b_i^{\mathrm{AFB}}(t)$ must be sampled. If the correct timing of the bits was known by the receiver, sampling with rate 1=$T_b$ would be sufficient. However, as the bit synchronization is not known yet, sampling is carried out with rate $N_{os}/T_b$ where $N_{os}$ is the analysis filter bank oversampling factor. By choosing $N_{os}$ sufficiently large (e.g. $N_{os}$ = 4), we can assure that at least one sampling cycle is close enough to the ideal bit synchronization. The decision on the best oversampling layer is made during the synchronization process, so all the oversampled data is kept until then. This process is described in detail in Section 3.4.

At the output of the i-th branch we have the coefficients $b_i^{\mathrm{AFB}}(j,k)$, where j indicates the bit number or time instant and k indicates the oversampling position within this single bit, where k = 1; 2; ...., Nos.

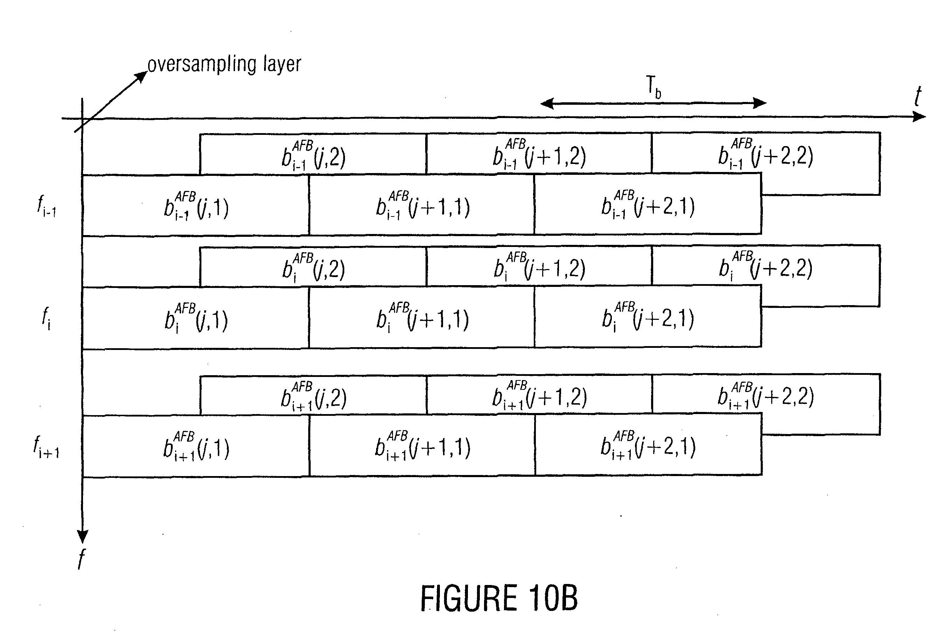

[0081] Figure 10b gives an exemplary overview of the location of the coefficients on the time-frequency plane. The oversampling factor is $N_{os}$ = 2. The height and the width of the rectangles indicate respectively the bandwidth and the time interval of the part of the signal that is represented by the corresponding coefficient $b_i^{\mathrm{AFB}}(j,k)$.

If the subband frequencies $f_i$ are chosen as multiples of a certain interval Δf the analysis filter bank can be efficiently implemented using the Fast Fourier Transform (FFT).

### 3.3.2 Amplitude normalization 1604

Without loss of generality and to simplify the description, we assume that the bit synchronization is known and that $N_{os}$ = 1 in the following. That is, we have complex coeffcients $b_i^{\mathrm{AFB}}(j)$ at the input of the normalization block 1604. As no channel state information is available at the receiver (i.e., the propagation channel in unknown), an equal gain combining (EGC) scheme is used. Due to the time and frequency dispersive channel, the energy of the sent bit $b_i$ (j) is not only found around the center frequency $f_i$ and time instant j, but also at adjacent frequencies and time instants. Therefore, for a more precise weighting, additional coefficients at frequencies $f_i \pm \Delta f$ are calculated and used for normalization of coefficient $b_i^{\mathrm{AFB}}(j)$. If $n$ = 1 we have, for example,

$$b_i^{\mathrm{norm}}(j) = \frac{b_i^{\mathrm{AFB}}(j)}{\sqrt{1/3 \cdot (|b_i^{\mathrm{AFB}}(j)|^2 + |b_{i-\Delta f}^{\mathrm{AFB}}(j)|^2 + |b_{i+\Delta f}^{\mathrm{AFB}}(j)|^2)}} \qquad (11)$$

The normalization for n > 1 is a straightforward extension of the formula above. In the same fashion we can also choose to normalize the soft bits by considering more than one time instant. The normalization is carried out for each subband i and each time instant j. The actual combining of the EGC is done at later steps of the extraction process.

### 3.3.3 Differential decoding 1608

At the input of the differential decoding block 1608 we have amplitude normalized complex coefficients $b_i^{\mathrm{norm}}(j)$ which contain information about the phase of the signal components at frequency $f_i$ and time instant j. As the bits are differentially encoded at the transmitter, the inverse operation must be performed here. The soft bits $\hat{b}_i$ (j) are obtained by first calculating the difference in phase of two consecutive coefficients and then taking the real part:

$$\widehat{b}_i(j) = \mathrm{Re}\{b_i^{\mathrm{norm}}(j) \cdot b_i^{\mathrm{norm}^*}(j-1)\} \qquad (12)$$

$$= \mathrm{Re}\{|b_i^{\mathrm{norm}}(j)| \cdot |b_i^{\mathrm{norm}}(j-1)| \cdot e^{j(\varphi_j - \varphi_{j-1})}\} \qquad (13)$$

This has to be carried out separately for each subband because the channel normally introduces different phase rotations in each subband.

### 3.4 The Synchronization Module 201

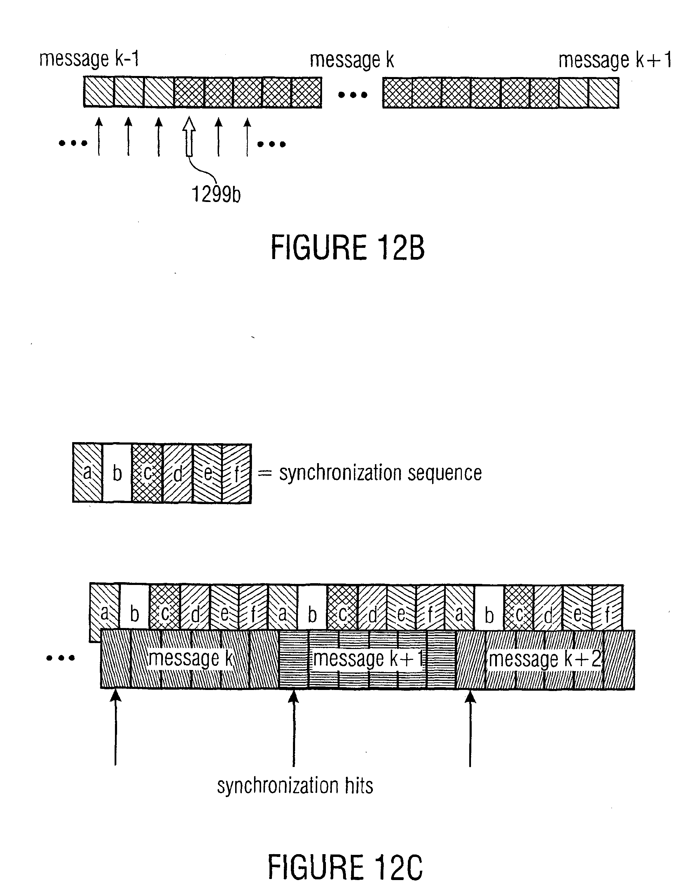

The synchronization module's task is to find the temporal alignment of the watermark. The problem of synchronizing the decoder to the encoded data is twofold. In a first step, the analysis filterbank must be aligned with the encoded data, namely the bit shaping functions $g_i^{\mathbf{T}}(t)$ used in the synthesis in the modulator must be aligned with the filters $g_i^{\mathbf{R}}(t)$ used for the analysis. This problem is illustrated in Figure 12a, where the analysis filters are identical to the synthesis ones. At the top, three bits are visible. For simplicity, the waveforms for all three bits are not scaled. The temporal offset between different bits is $T_b$. The bottom part illustrates the synchronization issue at the decoder: the filter can be applied at different time instants, however, only the position marked in red (curve 1299a) is correct and allows to extract the first bit with the best signal to noise ratio SNR and signal to interference ratio SIR. In fact, an incorrect alignment would lead to a degradation of both SNR and SIR. We refer to this first alignment issue as "bit synchronization". Once the bit synchronization has been achieved, bits can be extracted optimally. However, to correctly decode a message, it is necessary to know at which bit a new message starts. This issue is illustrated in Figure 12b and is referred to as message synchronization. In the stream of decoded bits only the starting position marked in red (position 1299b) is correct and allows to decode the k-th message.

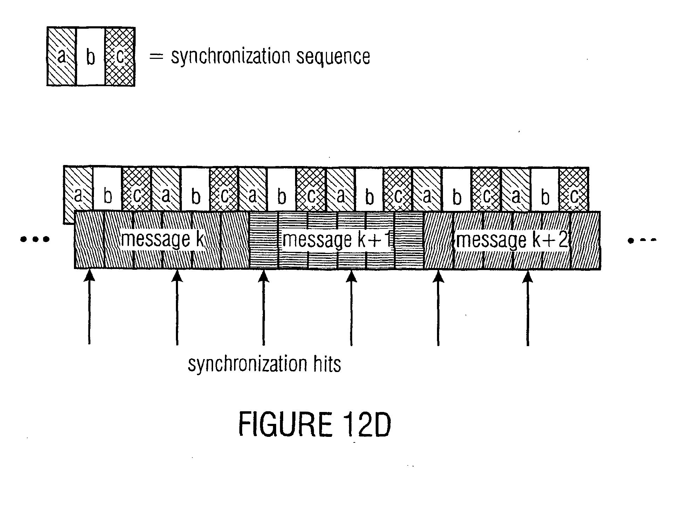

We first address the message synchronization only. The synchronization signature, as explained in Section 3.1, is composed of Ns sequences in a predetermined order which are embedded continuously and periodically in the watermark. The synchronization module is capable of retrieving the temporal alignment of the synchronization sequences. Depending on the size $N_s$ we can distinguish between two modes of operation, which are depicted in Figure 12c and 12d, respectively.

In the full message synchronization mode (Fig. 12c) we have $N_s = N_m/R_c$. For simplicity in the figure we assume $N_s = N_m/R_c = 6$ and no time spreading, i.e., $N_t = 1$. The synchronization signature used, for illustration purposes, is shown beneath the messages. In reality, they are modulated depending on the coded bits and frequency spreading sequences, as explained in Section 3.1. In this mode, the periodicity of the synchronization signature is identical to the one of the messages. The synchronization module therefore can identify the beginning of each message by finding the temporal alignment of the synchronization signature. We refer to the temporal positions at which a new synchronization signature starts as synchronization hits. The synchronization hits are then passed to the watermark extractor 202.

The second possible mode, the partial message synchronization mode (Fig. 12d), is depicted in Figure 12d. In this case we have $N_s < N_m = R_c$. In the figure we have taken $N_s = 3$, so that the three synchronization sequences are repeated twice for each message. Please note that the periodicity of the messages does not have to be multiple of the periodicity of the synchronization signature. In this mode of operation, not all synchronization hits correspond to the beginning of a message. The synchronization module has no means of distinguishing between hits and this task is given to the watermark extractor 202.

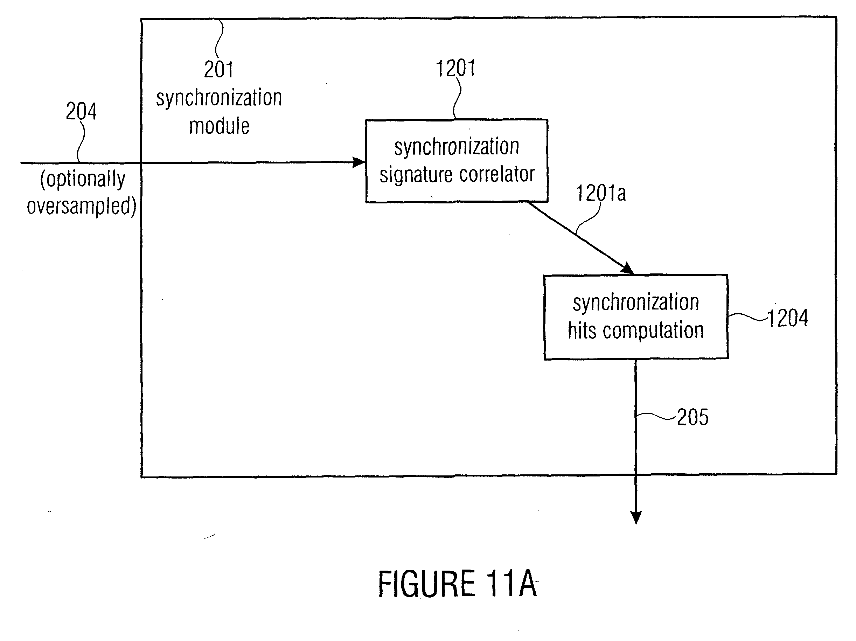

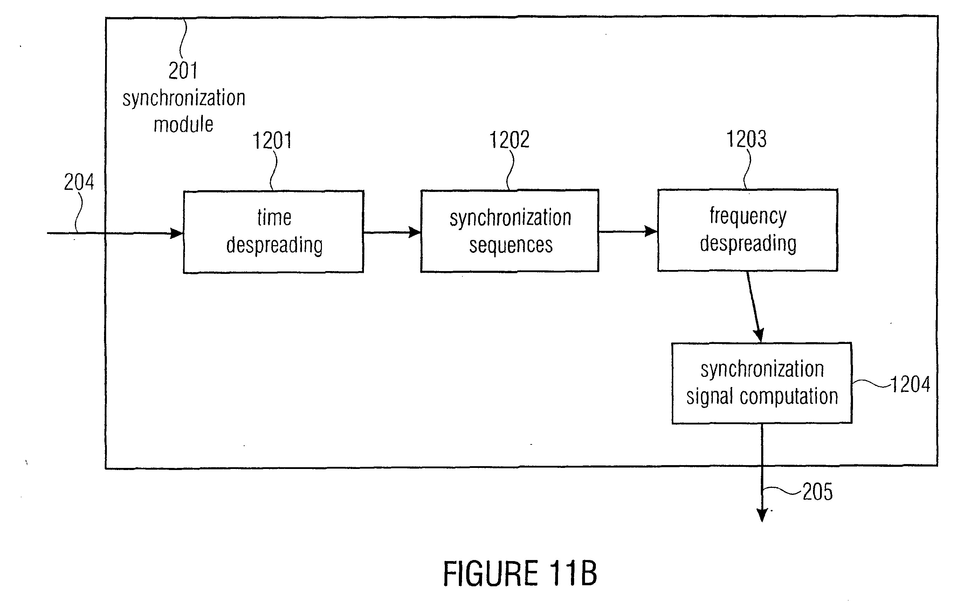

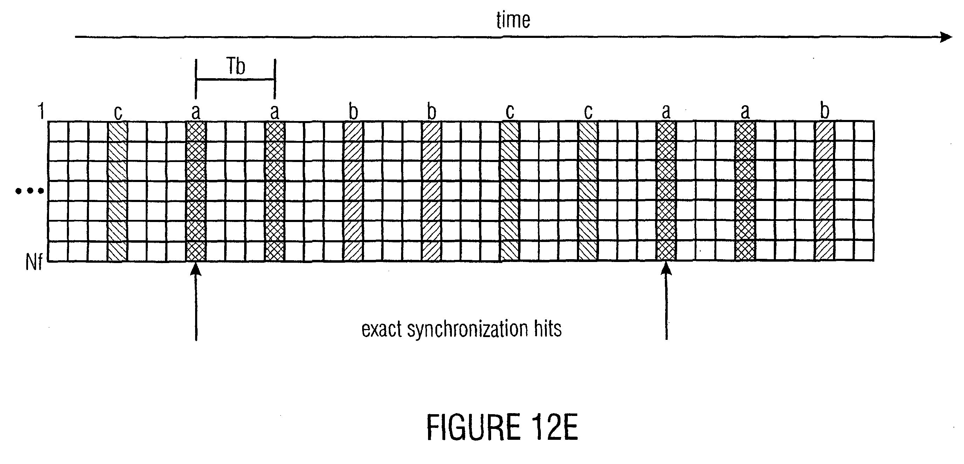

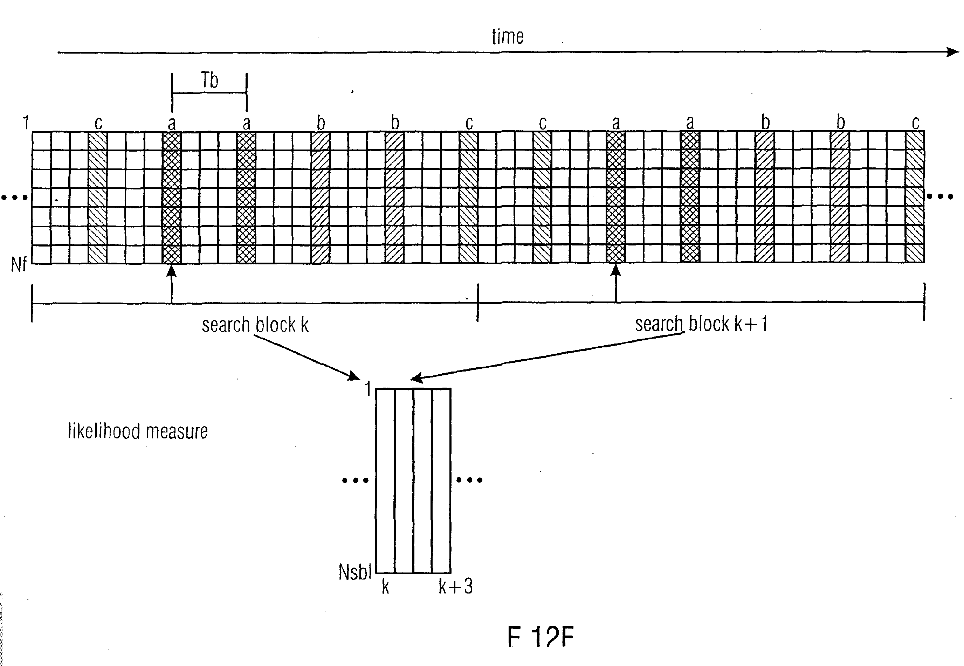

The processing blocks of the synchronization module are depicted in Figures 11a and 11b. The synchronization module carries out the bit synchronization and the message synchronization (either full or partial) at once by analyzing the output of the synchronization signature correlator 1201. The data in time/frequency domain 204 is provided by the analysis module. As the bit synchronization is not yet available, block 203 oversamples the data with factor $N_{os}$, as described in Section 3.3. An illustration of the input data is given in Figure 12e. For this example we have taken $N_{os} = 4$, $N_t = 2$, and $N_s = 3$. In other words, the synchronization signature consists of 3 sequences (denoted with a, b, and c). The time spreading, in this case with spreading sequence $c_t = [1\ 1]^T$, simply repeats each bit twice in time domain. The exact synchronization hits are denoted with arrows and correspond to the beginning of each synchronization signature. The period of the synchronization signature is $N_t \cdot N_{os} \cdot N_s = N_{sbl}$ which is $2 \cdot 4 \cdot 3 = 24$, for example. Due to the periodicity of the synchronization signature, the synchronization signature correlator (1201) arbitrarily divides the time axis in blocks, called search blocks, of size $N_{sbl}$, whose subscript stands for search block length. Every search block must contain (or typically contains) one synchronization hit as depicted in Figure 12f. Each of the $N_{sbl}$ bits is a candidate synchronization hit. Block 1201's task is to compute a likelihood measure for each of candidate bit of each block. This information is then passed to block 1204 which computes the synchronization hits.

### 3.4.1 The synchronization signature correlator 1201

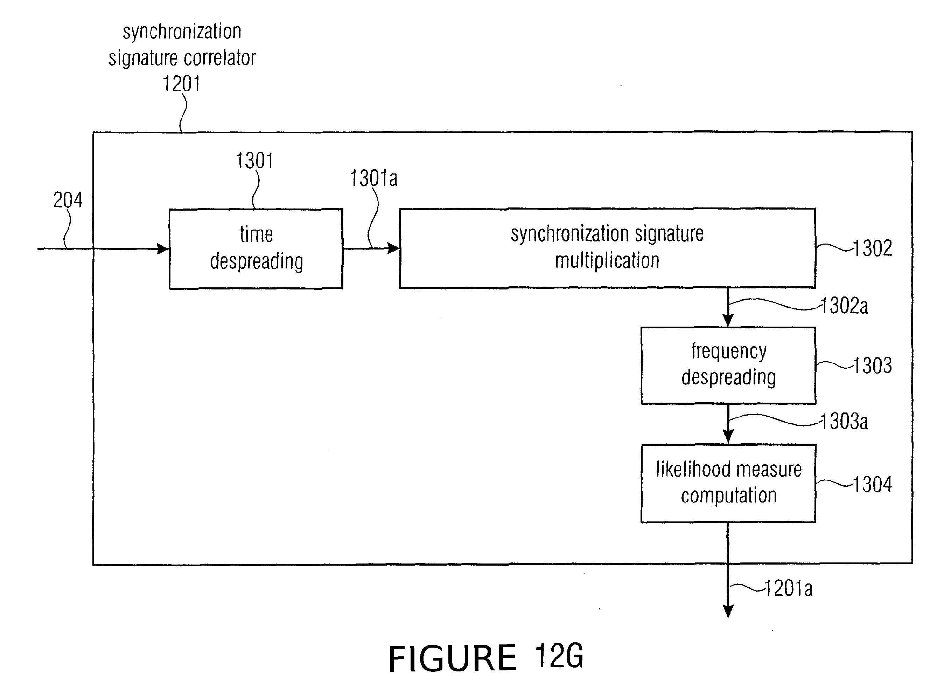

For each of the $N_{sbl}$ candidate synchronization positions the synchronization signature correlator computes a likelihood measure, the latter is larger the more probable it is that the temporal alignment (both bit and partial or full message synchronization) has been found. The processing steps are depicted in Figure 12g.

Accordingly, a sequence 1201aof likelihood values, associated with different positional choices, may be obtained.

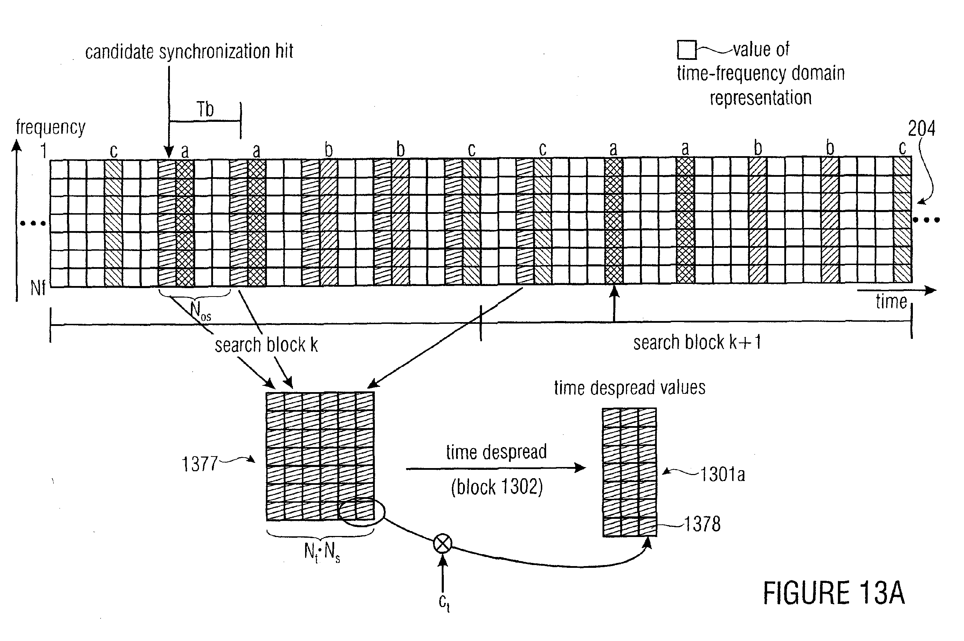

Block 1301 carries out the temporal despreading, i.e., multiplies every $N_t$ bits with the temporal spreading

sequence $c_t$ and then sums them. This is carried out for each of the $N_f$ frequency subbands. Figure 13a shows an example. We take the same parameters as described in the previous section, namely $N_{os}$ = 4, $N_t$ = 2, and $N_s$ = 3. The candidate synchronization position is marked. From that bit, with $N_{os}$ offset, $N_t \cdot N_s$ are taken by block 1301 and time despread with sequence $c_t$, so that Ns bits are left.

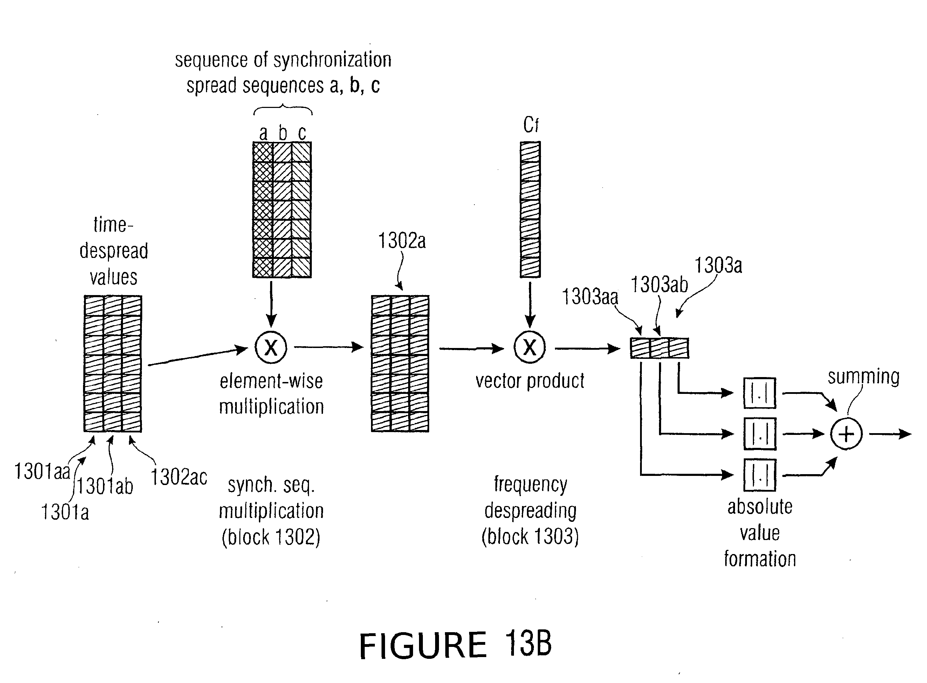

In block 1302 the bits are multiplied element-wise with the $N_s$ spreading sequences (see Figure 13b).

In block 1303 the frequency despreading is carried out, namely, each bit is multiplied with the spreading sequence $c_f$ and then summed along frequency.

At this point, if the synchronization position were correct, we would have $N_s$ decoded bits. As the bits are not known to the receiver, block 1304 computes the likelihood measure by taking the absolute values of the $N_s$ values and sums.

The output of block 1304 is in principle a non coherent correlator which looks for the synchronization signature. In fact, when choosing a small $N_s$, namely the partial message synchronization mode, it is possible to use synchronization sequences (e.g. **a, b, c**) which are mutually orthogonal. In doing so, when the correlator is not correctly aligned with the signature, its output will be very small, ideally zero. When using the full message synchronization mode it is advised to use as many orthogonal synchronization sequences as possible, and then create a signature by carefully choosing the order in which they are used. In this case, the same theory can be applied as when looking for spreading sequences with good auto correlation functions. When the correlator is only slightly misaligned, then the output of the correlator will not be zero even in the ideal case, but anyway will be smaller compared to the perfect alignment, as the analysis filters cannot capture the signal energy optimally.

### 3.4.2 Synchronization hits computation 1204

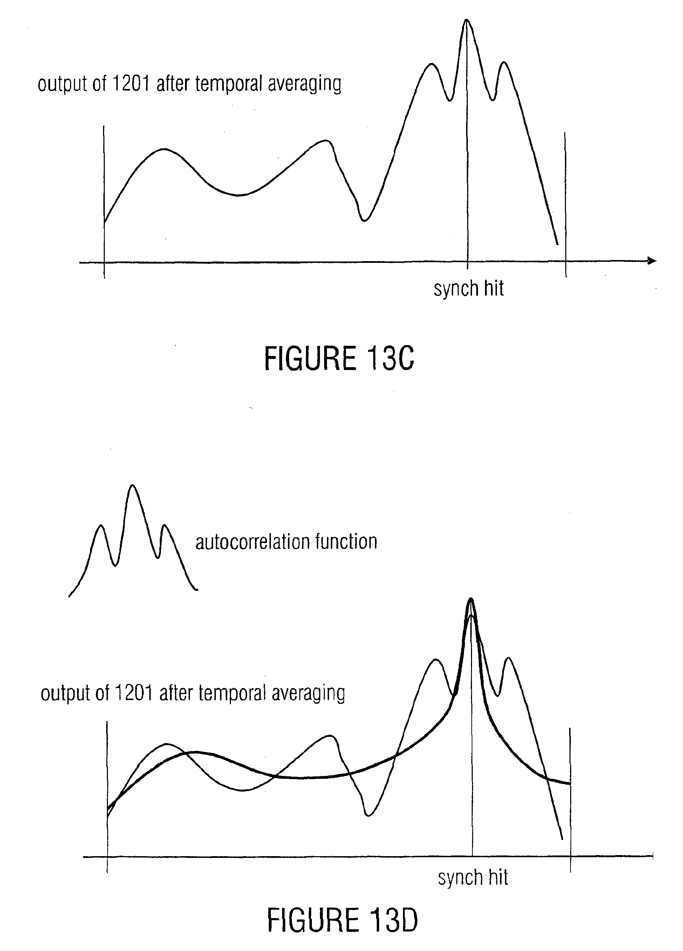

This block analyzes the output of the synchronization signature correlator to decide where the synchronization positions are. Since the system is fairly robust against misalignments of up to $T_b/4$ and the $T_b$ is normally taken around 40 ms, it is possible to integrate the output of 1201 over time to achieve a more stable synchronization. A possible implementation of this is given by an IIR filter applied along time with a exponentially decaying impulse response. Alternatively, a traditional FIR moving average filter can be applied. Once the averaging has been carried out, a second correlation along different $N_t \cdot N_s$ is carried out ("different positional choice"). In fact, we want to exploit the information that the autocorrelation function of the synchronization function is known. This corresponds to a Maximum Likelihood estimator. The idea is shown in Figure 13c. The curve shows the output of block 1201 after temporal integration. One possibility to determine the synchronization hit is simply to find the maximum of this function. In Figure 13d we see the same function (in black) filtered with the autocorrelation function of the synchronization signature. The resulting function is plotted in red. In this case the maximum is more pronounced and gives us the position of the synchronization hit. The two methods are fairly similar for high SNR but the second method performs much better in lower SNR regimes. Once the synchronization hits have been found, they are passed to the watermark extractor 202 which decodes the data.

In some embodiments, in order to obtain a robust synchronization signal, synchronization is performed in partial message synchronization mode with short synchronization signatures. For this reason many decodings have to be done, increasing the risk of false positive message detections. To prevent this, in some embodiments signaling sequences may be inserted into the messages with a lower bit rate as a consequence.

This approach is a solution to the problem arising from a sync signature shorter than the message, which is already addressed in the above discussion of the enhanced synchronization. In this case, the decoder doesn't know where a new message starts and attempts to decode at several synchronization points. To distinguish between legitimate messages and false positives, in some embodiments a signaling word is used (i.e. payload is sacrificed to embed a known control sequence). In some embodiments, a plausibility check is used (alternatively or in addition) to distinguish between legitimate messages and false positives.

### 3.5 The Watermark Extractor 202

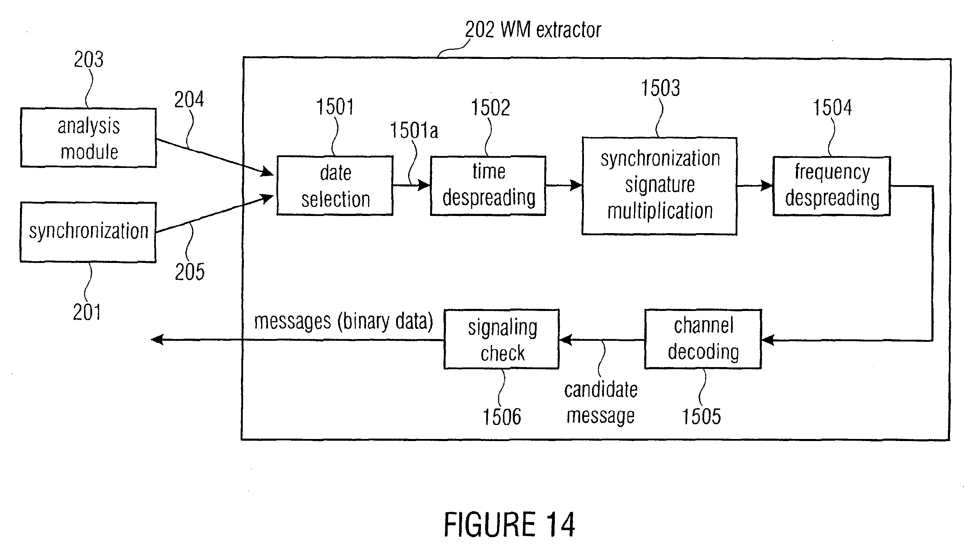

The parts constituting the watermark extractor 202 are depicted in Figure 14. This has two inputs, namely 204 and 205 from blocks 203 and 201, respectively. The synchronization module 201 (see Section 3.4) provides synchronization timestamps, i.e., the positions in time domain at which a candidate message starts. More details on this matter are given in Section 3.4. The analysis filterbank block 203, on the other hand, provides the data in time/frequency domain ready to be decoded.

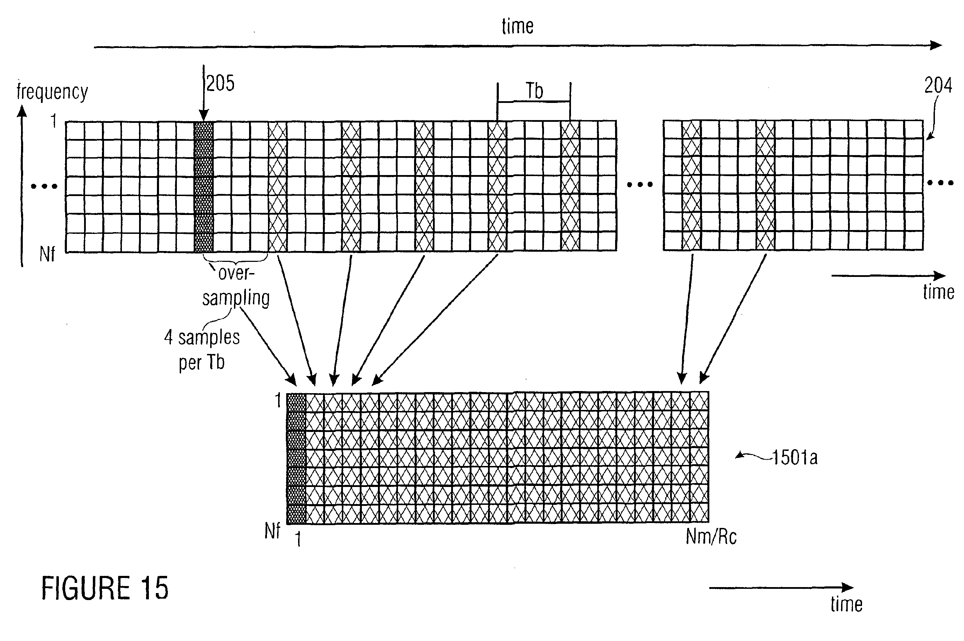

The first processing step, the data selection block 1501, selects from the input 204 the part identified as a candidate message to be decoded. Figure 15 shows this procedure graphically. The input 204 consists of $N_f$ streams of real values. Since the time alignment is not known to the decoder a priori, the analysis block 203 carries out a frequency analysis with a rate higher than $1/T_b$ Hz (oversampling). In Figure 15 we have used an oversampling factor of 4, namely, 4 vectors of size $N_f \times 1$ are output every $T_b$ seconds. When the synchronization block 201 identifies a candidate message, it delivers a timestamp 205 indicating the starting point of a candidate message. The selection block 1501 selects the information required for the decoding, namely a matrix of size $N_f \times N_m/R_c$. This matrix 1501a is given to block 1502 for further processing.

Blocks 1502, 1503, and 1504 carry out the same operations of blocks 1301, 1302, and 1303 explained in Section 3.4.

An alternative embodiment of the invention consists in avoiding the computations done in 1502-1504 by letting the synchronization module deliver also the data to be decoded. Conceptually it is a detail. From the implementation point of view, it is just a matter of how the buffers are realized. In general, redoing the computations allows us to have smaller buffers.

The channel decoder 1505 carries out the inverse operation of block 302. If channel encoder, in a possible embodiment of this module, consisted of a convolutional encoder together with an interleaver, then the channel decoder would perform the deinterleaving and the convolutional decoding, e.g., with the well known Viterbi algorithm. At the output of this block we have $N_m$ bits, i.e., a candidate message.

Block 1506, the signaling and plausibility block, decides whether the input candidate message is indeed a message or not. To do so, different strategies are possible.

The basic idea is to use a signaling word (like a CRC sequence) to distinguish between true and false messages. This however reduces the number of bits available as payload. Alternatively we can use plausibility checks. If the messages for instance contain a timestamp, consecutive messages must have consecutive timestamps. If a decoded message possesses a timestamp which is not the correct order, we can discard it.

When a message has been correctly detected the system may choose to apply the look ahead and/or look back mechanisms. We assume that both bit and message synchronization have been achieved. Assuming that the user is not zapping, the system "looks back" in time and attempts to decode the past messages (if not decoded already) using the same synchronization point (look back approach). This is particularly useful when the system starts. Moreover, in bad conditions, it might take 2 messages to achieve synchronization. In this case, the first message has no chance. With the look back option we can save "good" messages which have not been received only due to back synchronization. The look ahead is the same but works in the future. If we have a message now we know where the next message should be, and we can attempt to decode it anyhow.

3.6. Synchronization Details

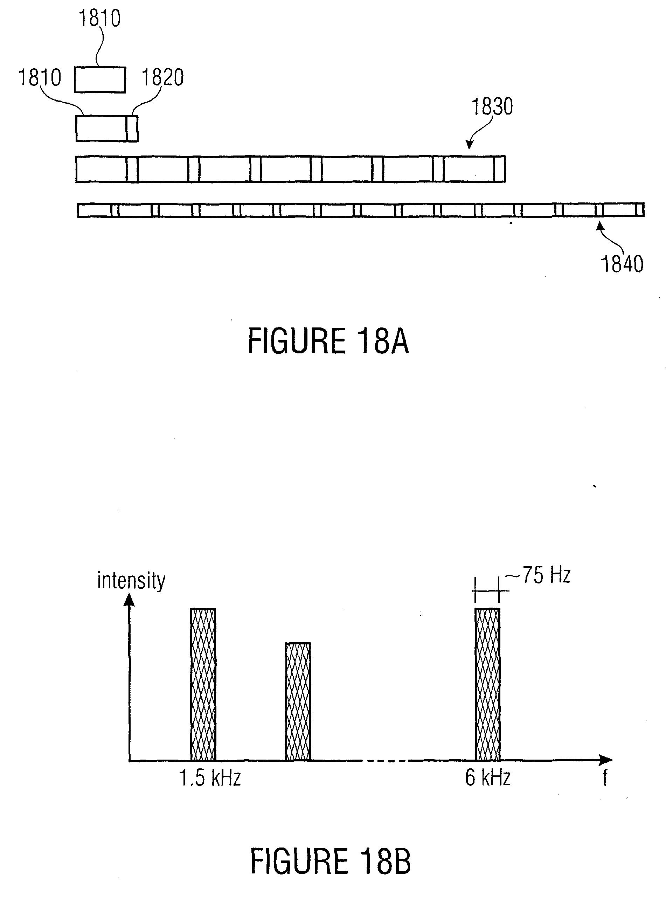

For the encoding of a payload, for example, a Viterbi algorithm may be used. Fig. 18a shows a graphical representation of a payload 1810, a Viterbi termination sequence 1820, a Viterbi encoded payload 1830 and a repetition-coded version 1840 of the Viterbi-coded payload. For example, the payload length may be 34 bits and the Viterbi termination sequence may comprise 6 bits. If, for example a Viterbi code rate of 1/7 may be used the Viterbi-coded payload may comprise (34+6)*7=280 bits. Further, by using a repetition coding of 1/2, the repetition coded version 1840 of the Viterbi-encoded payload 1830 may comprise 280*2=560 bits. In this example, considering a bit time interval of 42.66 ms, the message length would be 23.9 s. The signal may be embedded with, for example, 9 subcarriers (e.g. placed according to the critical bands) from 1.5 to 6 kHz as indicated by the frequency spectrum shown in Fig. 18b. Alternatively, also another number of subcarriers (e.g. 4, 6; 12, 15 or a number between 2 and 20) within a frequency range between 0 and 20 kHz maybe used.

Fig. 19 shows a schematic illustration of the basic concept 1900 for the synchronization, also called ABC synch. It shows a schematic illustration of an uncoded messages 1910, a coded message 1920 and a synchronization sequence (synch sequence) 1930 as well as the application of the synch to several messages 1920 following each other.

The synchronization sequence or synch sequence mentioned in connection with the explanation of this synchronization concept (shown in Fig. 19 - 23) may be equal to the synchronization signature mentioned before.

Further, Fig. 20 shows a schematic illustration of the synchronization found by correlating with the synch sequence. If the synchronization sequence 1930 is shorter than the message, more than one synchronization point 1940 (or alignment time block) may be found within a single message. In the example shown in Fig. 20, 4 synchronization points are found within each message. Therefore, for each synchronization found, a Viterbi decoder (a Viterbi decoding sequence) may be started. In this way, for each synchronization point 1940 a message 2110 may be obtained, as indicated in Fig. 21.

Based on these messages the true messages 2210 may be identified by means of a CRC sequence (cyclic redundancy check sequence) and/or a plausibility check, as shown in Fig. 22.

The CRC detection (cyclic redundancy check detection) may use a known sequence to identify true messages from false positive. Fig. 23 shows an example for a CRC sequence added to the end of a payload.

The probability of false positive (a message generated based on a wrong synchronization point) may depend on the length of the CRC sequence and the number of Viterbi decoders (number of synchronization points within a single message) started. To increase the length of the payload without increasing the probability of false positive a plausibility may be exploited (plausibility test) or the length of the synchronization sequence (synchronization signature) may be increased.

4. Concepts and Advantages

In the following, some aspects of the above discussed system will be described, which are considered as being innovative. Also, the relation of those aspects to the state-of the-art technologies will be discussed.

4.1. Continuous synchronization

Some embodiments allow for a continuous synchronization. The synchronization signal, which we denote as synchronization signature, is embedded continuously and parallel to the data via multiplication with sequences (also designated as synchronization spread sequences) known to both transmit and receive side.

Some conventional systems use special symbols (other than the ones used for the data), while some embodiments according to the invention do not use such special symbols. Other classical methods consist of embedding a known sequence of bits (preamble) time-multiplexed with the data, or embedding a signal frequency-multiplexed with the data.

However, it has been found that using dedicated sub-bands for synchronization is undesired, as the channel might have notches at those frequencies, making the synchronization unreliable. Compared to the other methods, in which a preamble or a special symbol is time-multiplexed with the data, the method described herein is more advantageous as the method described herein allows to track changes in the synchronization (due e.g. to movement) continuously.

Furthermore, the energy of the watermark signal is unchanged (e.g. by the multiplicative introduction of the watermark into the spread information representation), and the synchronization can be designed independent from the psychoacoustical model and data rate. The length in time of the synchronization signature, which determines the robustness of the synchronization, can be designed at will completely independent of the data rate.

Another classical method consists of embedding a synchronization sequence code-multiplexed with the data. When compared to this classical method, the advantage of the method described herein is that the energy of the data does not represent an interfering factor in the computation of the correlation, bringing more robustness. Furthermore, when using code-multiplexing, the number of orthogonal sequences available for the synchronization is reduced as some are necessary for the data.

To summarize, the continuous synchronization approach described herein brings along a large number of advantages over the conventional concepts.

However, in some embodiments according to the invention, a different synchronization concept may be applied.

4.2. 2D spreading

Some embodiments of the proposed system carry out spreading in both time and frequency domain, i.e. a 2-dimensional spreading (briefly designated as 2D-spreading). It has been found that this is advantageous with respect to ID systems as the bit error rate can be further reduced by adding redundance in e.g. time domain.

However, in some embodiments according to the invention, a different spreading concept may be applied.

4.3. Differential encoding and Differential decoding

In some embodiments according to the invention, an increased robustness against movement and frequency mismatch of the local oscillators (when compared to conventional systems) is brought by the differential modulation. It has been found that in fact, the Doppler effect (movement) and frequency mismatches lead to a rotation of the BPSK constellation (in other words, a rotation on the complex plane of the bits). In some embodiments, the detrimental effects of such a rotation of the BPSK constellation (or any other appropriate modulation constellation) are avoided by using a differential encoding or differential decoding.

However, in some embodiments according to the invention, a different encoding concept or decoding concept may be applied. Also, in some cases, the differential encoding may be omitted.

4.4. Bit shaping

In some embodiments according to the invention, bit shaping brings along a significant improvement of the system performance, because the reliability of the detection can be increased using a filter adapted to the bit shaping.

In accordance with some embodiments, the usage of bit shaping with respect to watermarking brings along improved reliability of the watermarking process. It has been found that particularly good results can be obtained if the bit shaping function is longer than the bit interval.

However, in some embodiments according to the invention, a different bit shaping concept may be applied. Also, in some cases, the bit shaping may be omitted.

4.5. Interactive between Psychoacoustic Model (PAM) and Filter Bank (FB) synthesis

In some embodiments, the psychoacoustical model interacts with the modulator to fine tune the amplitudes which multiply the bits.

However, in some other embodiments, this interaction may be omitted.

4.6. Look ahead and look back features

In some embodiments, so called "Look back" and "look ahead" approaches are applied.

In the following, these concepts will be briefly summarized. When a message is correctly decoded, it is assumed that synchronization has been achieved. Assuming that the user is not zapping, in some embodiments a look back in time is performed and it is tried to decode the past messages (if not decoded already) using the same synchronization point (look back approach). This is particularly useful when the system starts.

In bad conditions, it might take 2 messages to achieve synchronization. In this case, the first message has no chance in conventional systems. With the look back option, which is used in some embodiments of the invention, it is possible to save (or decode) "good" messages which have not been received only due to back synchronization.

The look ahead is the same but works in the future. If I have a message now I know where my next message should be, and I can try to decode it anyhow. Accordingly, overlapping messages can be decoded.

However, in some embodiments according to the invention, the look ahead feature and/or the look back feature may be omitted.

4.7. Increased synchronization robustness

In some embodiments, in order to obtain a robust synchronization signal, synchronization is performed in partial message synchronization mode with short synchronization signatures. For this reason many decodings have to be done, increasing the risk of false positive message detections. To prevent this, in some embodiments signaling sequences may be inserted into the messages with a lower bit rate as a consequence.

However, in some embodiments according to the invention, a different concept for improving the synchronization robustness may be applied. Also, in some cases, the usage of any concepts for increasing the synchronization robustness may be omitted.

4.8. Other enhancements

In the following, some other general enhancements of the above described system with respect to background art will be put forward and discussed:

1. lower computational complexity

2. better audio quality due to the better psychoacoustical model

3. more robustness in reverberant environments due to the narrowband multicarrier signals

4. an SNR estimation is avoided in some embodiments. This allows for better robustness, especially in low SNR regimes.

Some embodiments according to the invention are better than conventional systems, which use very narrow bandwidths of, for example, 8Hz for the following reasons:

1. 8 Hz bandwidths (or a similar very narrow bandwidth) requires very long time symbols because the psychoacoustical model allows very little energy to make it inaudible;

2. 8 Hz (or a similar very narrow bandwidth) makes it sensitive against time varying Doppler spectra. Accordingly, such a narrow band system is typically not good enough if implemented, e.g., in a watch.

Some embodiments according to the invention are better than other technologies for the following reasons:

1. Techniques which input an echo fail completely in reverberant rooms. In contrast, in some embodiments of the invention, the introduction of an echo is avoided.

2. Techniques which use only time spreading have longer message duration in comparison embodiments of the above described system in which a two-dimensional spreading, for example both in time and in frequency, is used.

Some embodiments according to the invention are better than the system described in DE 196 40 814, because one of more of the following disadvantages of the system according to said document are overcome:

- the complexity in the decoder according to DE 196 40 814 is very high, a filter of length 2N with N = 128 is used
- the system according to DE 196 40 814 comprises a long message duration
- in the system according to DE 196 40 814 spreading only in time domain with relatively high spreading gain (e.g. 128)
- in the system according to DE 196 40 814 the signal is generated in time domain, transformed to spectral domain, weighted, transformed back to time domain, and superposed to audio, which makes the system very complex

5. Applications

The invention comprises a method to modify an audio signal in order to hide digital data and a corresponding decoder capable of retrieving this information while the perceived quality of the modified audio signal remains indistinguishable to the one of the original.

Examples of possible applications of the invention are given in the following:

1. Broadcast monitoring: a watermark containing information on e.g. the station and time is hidden in the audio signal of radio or television programs. Decoders, incorporated in small devices worn by test subjects, are capable to retrieve the watermark, and thus collect valuable information for advertisements agencies, namely who watched which program and when.

2. Auditing: a watermark can be hidden in, e.g., advertisements. By automatically monitoring the transmissions of a certain station it is then possible to know when exactly the ad was broadcast. In a similar fashion it is possible to retrieve statistical information about the programming schedules of different radios, for instance, how often a certain music piece is played, etc.

3. Metadata embedding: the proposed method can be used to hide digital information about the music piece or program, for instance the name and author of the piece or the duration of the program etc.

6. Implementation Alternatives

Although some aspects have been described in the context of an apparatus, it is clear that these aspects also represent a description of the corresponding method, where a block or device corresponds to a method step or a feature of a method step. Analogously, aspects described in the context of a method step also represent a description of a corresponding block or item or feature of a corresponding apparatus. Some or all of the method steps may be executed by (or using) a hardware apparatus, like for example, a microprocessor, a programmable computer or an electronic circuit. In some embodiments, some one or more of the most important method steps may be executed by such an apparatus.

The inventive encoded watermark signal, or an audio signal into which the watermark signal is embedded, can be stored on a digital storage medium or can be transmitted on a transmission medium such as a wireless transmission medium or a wired transmission medium such as the Internet.

Depending on certain implementation requirements, examples can be implemented in hardware or in software. The implementation can be performed using a digital storage medium, for example a floppy disk, a DVD, a Blue-Ray, a CD, a ROM, a PROM, an EPROM, an EEPROM or a FLASH memory, having electronically readable control signals stored thereon, which cooperate (or are capable of cooperating) with a programmable computer system such that the respective method is performed. Therefore, the digital storage medium may be computer readable.

Some examples comprise a data carrier having electronically readable control signals, which are capable of cooperating with a programmable computer system, such that one of the methods described herein is performed.

Generally, examples can be implemented as a computer program product with a program code, the program code being operative for performing one of the methods when the computer program product runs on a computer. The program code may for example be stored on a machine readable carrier.

Other examples comprise the computer program for performing one of the methods described herein, stored on a machine readable carrier.

In other words, an example of a method is, therefore, a computer program having a program code for performing one of the methods described herein, when the computer program runs on a computer.

A further example of the methods is, therefore, a data carrier (or a digital storage medium, or a computer-readable medium) comprising, recorded thereon, the computer program for performing one of the methods described herein.

A further example of a method is, therefore, a data stream or a sequence of signals representing the computer program for performing one of the methods described herein. The data stream or the sequence of signals may for example be configured to be transferred via a data communication connection, for example via the Internet.

A further example comprises a processing means, for example a computer, or a programmable logic device, configured to or adapted to perform one of the methods described herein.

A further example comprises a computer having installed thereon the computer program for performing one of the methods described herein.

In some examples, a programmable logic device (for example a field programmable gate array) may be used to perform some or all of the functionalities of the methods described herein. In some examples, a field programmable gate array may cooperate with a microprocessor in order to perform one of the methods described herein. Generally, the methods are preferably performed by any hardware apparatus.

The above described examples are merely illustrative for the principles of the present invention. It is understood that modifications and variations of the arrangements and the details described herein will be apparent to others skilled in the art. It is the intent, therefore, to be limited only by the scope of the impending patent claims and not by the specific details presented by way of description and explanation of the embodiments herein.

## Claims

1. A watermark generator (101;2400) for providing a watermark signal (101b; 2420) in dependence on binary message data (101a, **m**; 2410), the watermark generator comprising:

   an information processor (303, 304, 305) configured to provide, in dependence on a single message bit of the binary message data, a 2-dimensional spread information (b(i,j); 2432) representing the message bit in the form of a set of time-frequency-domain values; and
   a watermark signal provider (306,307) configured to provide the watermark signal on the basis of the 2-dimensional spread information;
   wherein the information processor is configured to spread a first message bit in a first spreading direction using a first spread sequence ($c_f$) and to spread a second message bit in the first spreading direction using the first spread sequence ($c_f$), in order to obtain an intermediate information representation (303a, $c_f \cdot m$), to combine the intermediate information representation with an overlay information representation (**S**), in order to obtain a combined information representation (**C**),
   and to spread the combined information representation in a second direction using a second spread sequence ($c_t$), in order to obtain the 2-dimensional spread information,
   wherein the information processor is configured to combine the intermediate information representation with an overlay information representation, which is spread in the first spreading direction using a plurality of overlay information spreading sequences (**a,b**), such that the first spread message bit is multiplied with a first overlay information spread sequence (**a**), and such that the second spread message bit is multiplied with a second overlay information spread sequence (**b**),
   wherein the first overlay information spread sequence and the second overlay information spread sequence are orthogonal.

2. The watermark generator according to claim 1, wherein the first spread sequence ($c_f$) comprises a size $N_f \times 1$ wherein $N_f$ is a frequency spreading width.

3. The watermark generator according to claim 1 or claim 2, wherein the first spread sequence defines a spreading in frequency direction only.

4. The watermark generator according to one of claims 1 to 2, wherein the information processor is configured to spread the message bit in a first spreading direction using a first spread sequence ($c_f$), in order to obtain an intermediate information representation (303a, $c_f$ m), to combine the intermediate information representation with an overlay information representation (S), in order to obtain a combined information representation (C), and to spread the combined information representation in a second direction using a second spread sequence ($c_t$), in order to obtain the 2-dimensional spread information.

5. The watermark generator according to claim 4, wherein the information processor is configured to combine the intermediate information representation with an
overlay information representation, which is spread in the first spreading direction using an overlay information spreading sequence (a), such that the message bit and the overlay information are spread with different spreading sequences (cf, a) in the first spreading direction, and such that the combination of the message bit and the overlay information is spread with a common spreading sequence ($c_t$) in the second spreading direction.

6. The watermark generator according to claim 4 or 5, wherein the information processor is configured to multiplicatively combine the intermediate information representation (303a, cf m) with the overlay information representation (S), and to spread the combined information representation, which comprises product values formed in dependence on values of the intermediate information representation and values of the overlap information, in the second spreading direction using the second spreading sequence ($c_t$), such that the product values are spread using a common spread sequence.

7. The watermark generator according to one of claims 1 to 2 and 4 to 6, wherein the information processor is configured to selectively spread a given message bit onto a first bit representation, which is a positive multiple of a bit spread sequence ($c_f$, or onto a second bit representation, which is a negative multiple of the bit spread sequence ($c_f$), in dependence on the value of the given bit, in order to spread the message bit in the first spreading direction.

8. The watermark generator according to one of claims 1 to 2 and 4 to 7, wherein the information processor is configured to map a given value of an intermediate information representation, which is obtained by spreading the message bit in the first spreading direction,
or a given value of a combined information representation, which is obtained by spreading the message bit in the first spreading direction and combining the result thereof with an overlay information representation,
onto a set of spread values, such that the set of spread values is a scaled version of a second spread sequence ($c_t$), scaled in accordance with the given value.

9. The watermark generator according to one of claims 1 to 2 and 4 to 8, wherein the information processor is configured to obtain, as an intermediate information representation, a spread information representation R according to

$$\mathbf{R} = \mathbf{c_f} \cdot \mathbf{m},$$

wherein $c_f$ is a vector of size $N_f \times 1$ representing a bit spreading sequence of frequency spreading width $N_f$,
wherein m is a vector of size $1 \times N_{mc}$ representing $N_{mc}$ bits of the binary message data, wherein different binary values of the bits are represented by entries of the vector m having different sign and
wherein "·" designates a matrix multiplication operator, and
wherein the information processor is configured to obtain the 2-dimensional spread information B using an operation

$$\mathbf{B} = \mathbf{R'} \, \Diamond \, \mathbf{c_t}^{\mathbf{T}},$$

wherein R' is equal to R or obtained by combining R with an overlay information (S);
wherein $\Diamond$ designates a Kronecker product operator, and
wherein T designates a transpose operator.

10. A watermark decoder (200; 2500) for providing binary message data (202a; 2520) in dependence on a watermarked signal (200a, r(t); 2510), the watermark decoder comprising:

a time-frequency-domain representation provider (203; 2530) configured to provide a time-frequency-domain representation (204;2532) of the watermarked signal;

a synchronization determinator (201;2540) comprising a despreader having one or more despreader blocks (1201, 1203; 2542), wherein the despreader is configured to perform a 2-dimensional despreading in order to obtain a synchronization information (205; 2544) in dependence on a 2-dimensional portion of the time-frequency-domain representation; and

a watermark extractor (202; 2550) configured to extract the binary message data from the time-frequency-domain representation of the watermarked signal using the synchronization information;

wherein the despreader is configured to obtain a set of temporally despread values,

wherein the despreader is configured to multiply a plurality of values of the time-frequency-domain representation with values of a temporal despread sequence ($c_t$),

and to add results of the multiplications in order to obtain one of the temporally despread values, and

wherein the despreader is configured to multiply the temporally despread values with values of a frequency despread sequence in an element-wise manner, and to add results of the multiplications to obtain a 2-dimensionally despread value;

wherein the despreader is configured to multiply subsequent sets of temporally despread values with values of different frequency despread sequences in an element-wise manner, such that a first set of the temporally despread values is effectively multiplied, in an element-wise manner and in a one-step or multi-step multiplication, with a first combined frequency despread sequence, which is a product of a common frequency despread sequence and a first overlay despread sequence, and such that a second set of the temporally despread values is effectively multiplied, in an element-wise manner and in a one-step or multi-step multiplication, with a second combined frequency despread sequence, which is a product of the common frequency despread sequence and a second overlay despread sequence, which is different from the first overlay frequency despread sequence, wherein the first overlay despread sequence and the second overlay despread sequence are orthogonal.

11. A watermark decoder (200; 2560) for providing binary message data (202a; 2580) in dependence on a watermarked signal (200a, r(t); 2570), the watermark decoder comprising:

a time-frequency-domain representation provider (203; 2590)configured to provide a time-frequency-domain representation (204;2592) of the watermarked signal; and

a watermark extractor (202; 2596) comprising a despreader having one or more despreader blocks, wherein the despreader is configured to perform a 2-dimensional despreading in order to obtain a bit of the binary message data in dependence on a 2-dimensional portion of the time-frequency-domain representation;

· wherein the despreader is configured to obtain a set of temporally despread values, wherein the despreader is configured to multiply a plurality of values of the time-frequency-domain representation with values of a temporal despread sequence ($c_t$), and to add results of the multiplications in order to obtain one of the temporally despread values, and

wherein the despreader is configured to multiply the temporally despread values with values of a frequency despread sequence in an element-wise manner, and to add results of the multiplications to obtain a 2-dimensionally despread value;

wherein the despreader is configured to multiply subsequent sets of temporally despread values with values of different frequency despread sequences in an element-wise manner, such that a first set of the temporally despread values is effectively multiplied, in an element-wise manner and in a one-step or multi-step multiplication, with a first combined frequency despread sequence, which is a product of a common frequency despread sequence and a first overlay despread sequence, and such that a second set of the temporally despread values is effectively multiplied, in an element-wise manner and in a one-step or multi-step multiplication, with a second combined frequency despread sequence, which is a product of the common frequency despread sequence and a second overlay despread sequence, which is different from the first overlay frequency despread sequence, wherein the first overlay despread sequence and the second overlay despread sequence are orthogonal.

12. The watermark decoder according to claim 10 or claim 11, wherein the despreader is configured to multiply a plurality of values of the time-frequency-domain representation (1377) with values of a temporal despread sequence ($c_f$) and to add results of the multiplications in order to obtain a temporally despread value (1378), and wherein the despreader is configured to multiply a plurality of temporally despread values associated with different frequencies of the time-frequency-domain representation, or values derived therefrom, with a frequency despread sequence ($c_f$) in an element-wise manner and to add results of the multiplication in order to obtain a 2-dimensionally despread value.

13. The watermark decoder according to one of claims 10 to 12, wherein the despreader is configured to obtain a set of temporally despread values, wherein the despreader is configured to multiply a plurality of values of the time-frequency-domain representation with values of a temporal despread sequence ($c_t$), and to add results of the multiplications in order to obtain one of the temporally despread values, and wherein the despreader is configured to multiply the temporally despread values with values of a frequency despread sequence in an element-wise manner, and to add results of the multiplications to obtain a 2-dimensionally despread value.

14. The watermark decoder according to claim 13, wherein the despreader is configured to multiply subsequent sets of temporally despread values with values of different frequency despread sequences in an element-wise manner, such that a first set of the temporally despread values is effectively multiplied, in an element-wise manner and in a one-step or multi-step multiplication, with a first combined frequency despread sequence, which is a product of a common frequency despread sequence and a first overlay despread sequence, and such that a second set of the temporally despread values is effectively multiplied, in an element-wise manner and in a one-step or multi-step multiplication, with a second combined frequency despread sequence, which is a product of the common frequency despread sequence and a second overlay despread sequence, which is different from the first overlay frequency despread sequence.

15. A method (2600) for providing a watermark signal in dependence on binary message data, the method comprising:

Providing (2610), in dependence on a single message bit of the binary message data, a 2-dimensional spread information representing the message bit in the form of a set of time-frequency-domain values; and
providing (2620) the watermark signal on the basis of the 2-dimensional spread information;
wherein a first message bit is spread in a first spreading direction using a first spread sequence ($c_f$) and a second message bit is spread in the first spreading direction using the first spread sequence ($c_f$), in order to obtain an intermediate information representation (303a, $c_f \cdot m$), and wherein the intermediate information representation is combined with an overlay information representation ($S$), in order
to obtain a combined information representation ($C$), and wherein the combined information representation is spread in a second direction using a second spread sequence ($c_t$), in order to obtain the 2-dimensional spread information,
wherein the intermediate information representation is combined with an overlay information representation, which is spread in the first spreading direction using a plurality of overlay information spreading sequences ($a$, $b$), such that the first spread message bit is multiplied with a first overlay information spread sequence ($a$), and such that the second spread message bit is multiplied with a second overlay information spread sequence ($b$), wherein the first overlay information spread sequence and the second overlay information spread sequence are orthogonal..

16. A method (2700) for providing binary message data in dependence on a watermarked signal, the method comprising:

providing (2710) a time-frequency-domain representation of the watermarked signal; and
performing (2720) a 2-dimensional despreading in order to obtain a bit of the binary message data or a synchronization information used to extract the binary message data from the time-frequency-domain representation of the watermark signal in dependence on a 2-dimensional portion of the time-frequency-domain representation;
wherein a set of temporally despread values is obtained, wherein a plurality of values of the time-frequency-domain representation is multiplied with values of a temporal despread sequence ($c_t$), and wherein results of the multiplications are added in order to obtain one of the temporally despread values, and
wherein the temporally despread values are multiplied with values of a frequency despread sequence in an element-wise manner, and wherein results of the multiplications are added to obtain a 2-dimensionally despread value;
wherein subsequent sets of temporally despread values are multiplied with values of different frequency despread sequences in an element-wise manner, such that a first set of the temporally despread values is effectively multiplied, in an element-wise manner and in a one-step or multi-step multiplication, with a first combined frequency despread sequence, which is a product of a common frequency despread sequence and a first overlay despread sequence, and such that a second set of the temporally despread values is effectively multiplied, in an element-wise manner and in a one-step or multi-step multiplication, with a second combined frequency despread sequence, which is a product of the common frequency despread sequence and a second overlay despread sequence, which is different from the first overlay frequency despread sequence,
wherein the first overlay despread sequence and the second overlay despread sequence are orthogonal.

17. A computer program adapted to perform the method according to claim 15 or claim 16, when the computer program runs on a computer.

## Patentansprüche

1. Eine Wasserzeichenerzeugungseinrichtung (101; 2400) zum Bereitstellen eines Wasserzeichensignals (101b; 2420) in Abhängigkeit von binären Nachrichtendaten (101a, m; 2410), wobei die Wasserzeichenerzeugungseinrichtung folgende Merkmale aufweist:

   einen Informationsprozessor (303, 304, 305), der dazu konfiguriert ist, in Abhängigkeit von einem einzelnen Nachrichtenbit der binären Nachrichtendaten zweidimensionale gespreizte Informationen (b(i,j); 2432) bereitzustellen, die das Nachrichtenbit in Form eines Satzes von Zeit-Frequenz-Bereichswerten darstellen; und einen Wasserzeichensignalbereitsteller (306, 307), der dazu konfiguriert ist, das Wasserzeichensignal auf der Basis der zweidimensionalen gespreizten Informationen bereitzustellen;
   wobei der Informationsprozessor dazu konfiguriert ist, ein erstes Nachrichtenbit in einer ersten Spreizrichtung unter Verwendung einer ersten Spreizsequenz ($C_f$) zu spreizen und ein zweites Nachrichtenbit in der ersten Spreizrichtung unter Verwendung der ersten Spreizsequenz ($C_f$) zu spreizen, um eine Zwischeninformationsdarstellung (303a, $c_f \cdot m$) zu erhalten, die Zwischeninformationsdarstellung mit einer Überlagerungsinformationsdarstellung (S) zu kombinieren, um eine kombinierte Informationsdarstellung (C) zu erhalten, und die kombinierte Informationsdarstellung in einer zweiten Richtung unter Verwendung einer zweiten Spreizsequenz ($c_t$) zu spreizen, um die zweidimensionalen gespreizten Informationen zu erhalten,
   wobei der Informationsprozessor dazu konfiguriert ist, die Zwischeninformationsdarstellung mit einer Überlagerungsinformationsdarstellung zu kombinieren, die in der ersten Spreizrichtung unter Verwendung einer Mehrzahl von Überlagerungsinformationsspreizsequenzen (a,b) gespreizt wird, derart, dass das erste gespreizte Nachrichtenbit mit einer ersten Überlagerungsinformationsspreizsequenz (a) multipliziert wird, und derart, dass das zweite gespreizte Nachrichtenbit mit einer zweiten Überlagerungsinformationsspreizsequenz (b) multipliziert wird,
   wobei die erste Überlagerungsinformationsspreizsequenz und die zweite Überlagerungsinformationsspreizsequenz orthogonal sind.

2. Die Wasserzeichenerzeugungseinrichtung gemäß Anspruch 1, bei der die erste Spreizsequenz ($c_f$) eine Größe $N_f$ x 1 aufweist, wobei $N_f$ eine Frequenzspreizbreite ist.

3. Die Wasserzeichenerzeugungseinrichtung gemäß Anspruch 1 oder Anspruch 2, bei der die erste Spreizsequenz eine Spreizung lediglich in der Frequenzrichtung definiert.

4. Die Wasserzeichenerzeugungseinrichtung gemäß einem der Ansprüche 1 bis 2, bei der der Informationsprozessor dazu konfiguriert ist, das Nachrichtenbit in einer ersten Spreizrichtung unter Verwendung einer ersten Spreizsequenz ($c_f$) zu spreizen, um eine Zwischeninformationsdarstellung (303a, $c_f \cdot m$) zu erhalten, die Zwischeninformationsdarstellung mit einer Überlagerungsinformationsdarstellung (S) zu kombinieren, um eine kombinierte Informationsdarstellung (C) zu erhalten, und die kombinierte Informationsdarstellung in einer zweiten Richtung unter Verwendung einer zweiten Spreizsequenz ($c_t$) zu spreizen, um die zweidimensionalen gespreizten Informationen zu erhalten,

5. Die Wasserzeichenerzeugungseinrichtung gemäß Anspruch 4, bei der der Informationsprozessor dazu konfiguriert ist, die Zwischeninformationsdarstellung mit einer Überlagerungsinformationsdarstellung zu kombinieren, die in der ersten Spreizrichtung unter Verwendung einer Überlagerungsinformationsspreizsequenz (a) gespreizt wird, derart, dass das Nachrichtenbit und die Überlagerungsinformationen mit unterschiedlichen Spreizsequenzen ($C_f$, a) in der ersten Spreizrichtung gespreizt werden, und derart, dass die Kombination des Nachrichtenbits und der Überlagerungsinformationen mit einer gemeinsamen Spreizsequenz ($c_t$) in der zweiten Spreizrichtung gespreizt wird.

6. Die Wasserzeichenerzeugungseinrichtung gemäß Anspruch 4 oder 5, bei der der Informationsprozessor dazu konfiguriert ist, die Zwischeninformationsdarstellung (303a, $c_f \cdot m$) auf multiplikatorische Weise mit der Überlagerungsinformationsdarstellung (S) zu kombinieren und die kombinierte Informationsdarstellung, die Produktwerte aufweist, die in Abhängigkeit von Werten der Zwischeninformationsdarstellung und Werten der Überlappungsinformationen gebildet werden, in der zweiten Spreizrichtung unter Verwendung der zweiten Spreizsequenz ($c_t$) zu spreizen, derart, dass die Produktwerte unter Verwendung einer gemeinsamen Spreizsequenz gespreizt werden.

7. Die Wasserzeichenerzeugungseinrichtung gemäß einem der Ansprüche 1 bis 2 und 4 bis 6, bei der der Informationsprozessor dazu konfiguriert ist, ein gegebenes Nachrichtenbit in Abhängigkeit von dem Wert des gegebenen Bits selektiv auf eine erste Bitdarstellung, die ein positives Vielfaches einer Bitspreizsequenz ($c_f$) ist, oder auf eine zweite Bitdarstellung, die ein negatives Vielfaches der Bitspreizsequenz ($c_f$) ist, zu spreizen, um das Nachrichtenbit in der ersten Spreizrichtung zu spreizen.

8. Die Wasserzeichenerzeugungseinrichtung gemäß einem der Ansprüche 1 bis 2 und 4 bis 7, bei der der Informationsprozessor dazu konfiguriert ist, einen gegebenen Wert einer Zwischeninformationsdarstellung, der durch Spreizen des Nachrichtenbits in der ersten Spreizrichtung erhalten wird,

oder einen gegebenen Wert einer kombinierten Informationsdarstellung, der durch ein Spreizen des Nachrichtenbits in der ersten Spreizrichtung und durch Kombinieren des Ergebnisses dessen mit einer Überlagerungsinformationsdarstellung erhalten wird,

auf einen Satz gespreizter Werte abzubilden, derart, dass der Satz gespreizter Werte eine skalierte Version einer zweiten Spreizsequenz ($c_t$) ist, die gemäß dem gegebenen Wert skaliert ist.

9. Die Wasserzeichenerzeugungseinrichtung gemäß einem der Ansprüche 1 bis 2 und 4 bis 8, bei der der Informationsprozessor dazu konfiguriert ist, als Zwischeninformationsdarstellung eine gespreizte Informationsdarstellung R gemäß

$$R = c_f \cdot m,$$

zu erhalten, wobei $c_f$ ein Vektor der Größe $N_f$ x 1 ist, der eine Bitspreizsequenz der Frequenzspreizbreite $N_f$ darstellt, wobei m ein Vektor der Größe 1 x $N_{mc}$ ist, der $N_{mc}$ Bits der binären Nachrichtendaten darstellt, wobei unterschiedliche binäre Werte der Bits durch Einträge des Vektors m mit unterschiedlichem Vorzeichen dargestellt werden, und wobei "·" einen Matrixmultiplikationsoperator bezeichnet; und

wobei der Informationsprozessor dazu konfiguriert ist, die zweidimensionalen gespreizten Informationen B unter Verwendung einer Operation

$$B = R' \lozenge c_t^T$$

zu erhalten, wobei R' gleich R ist oder erhalten wird, indem R mit Überlagerungsinformationen (S) kombiniert wird; wobei $\lozenge$ einen Kronecker-Produkt-Operator bezeichnet, und wobei $^T$ einen Transpositionsoperator bezeichnet.

10. Ein Wasserzeichendecodierer (200; 2500) zum Bereitstellen von binären Nachrichtendaten (202a; 2520) in Abhängigkeit von einem mit einem Wasserzeichen markierten Signal (200a, r(t); 2510), wobei der Wasserzeichendecodierer folgende Merkmale aufweist:

einen Zeit-Frequenz-Bereichsdarstellungsbereitsteller (203; 2530), der dazu konfiguriert ist, eine Zeit-Frequenz-Bereichsdarstellung (204; 2532) des mit einem Wasserzeichen markierten Signals bereitzustellen;
einen Synchronisationsbestimmer (201; 2540), der eine Entspreizvorrichtung aufweist, die einen oder mehrere Entspreizungseinrichtungsblöcke (1201, 1203; 2542) aufweist, wobei die Entspreizungseinrichtung dazu konfiguriert ist, eine zweidimensionale Entspreizung durchzuführen, um in Abhängigkeit von einem zweidimensionalen Teil der Zeit-Frequenz-Bereichsdarstellung Synchronisationsinformationen (205; 2544) zu erhalten; und
eine Wasserzeichen-Extraktionseinrichtung (202; 2550), die dazu konfiguriert ist, die binären Nachrichtendaten unter Verwendung der Synchronisationsinformationen aus der Zeit-Frequenz-Bereichsdarstellung des mit einem Wasserzeichen markierten Signals zu extrahieren;
wobei die Entspreizungseinrichtung dazu konfiguriert ist, einen Satz von zeitlich entspreizten Werten zu erhalten,
wobei die Entspreizungseinrichtung dazu konfiguriert ist, eine Mehrzahl von Werten der Zeit-Frequenz-Bereichsdarstellung mit Wer-ten einer Zeitentspreizungssequenz ($c_t$) zu multiplizieren und Ergebnisse der Multiplikationen zu addieren, um einen der zeitlich entspreizten Werte zu erhalten, und
wobei die Entspreizungseinrichtung dazu konfiguriert ist, die zeitlich entspreizten Werte mit Werten einer Frequenzentspreizungssequenz elementweise zu multiplizieren und Ergebnisse der Multiplikationen zu addieren, um einen zweidimensional entspreizten Wert zu erhalten;

wobei die Entspreizungseinrichtung dazu konfiguriert ist, nachfolgende Sätze von zeitlich entspreizten Werten mit Werten verschiedener Frequenzentspreizungssequenzen elementweise zu multiplizieren, sodass ein erster Satz der zeitlich entspreizten Werte elementweise und in einer einen Schritt oder mehrere Schritte umfassenden Multiplikation mit einer ersten kombinierten Frequenzentspreizungssequenz effektiv multipliziert wird, die ein Produkt einer gemeinsamen Frequenzentspreizungssequenz und einer ersten Überlagerungsentspreizungssequenz ist,

und sodass ein zweiter Satz der zeitlich entspreizten Werte elementweise und in einer einen Schritt oder mehrere Schritte umfassenden Multiplikation effektiv mit einer zweiten kombinierten Frequenzentspreizungssequenz multipliziert wird, die ein Produkt der gemeinsamen Frequenzentspreizungssequenz und einer zweiten Überlagerungsentspreizungssequenz ist, die sich von der ersten Überlagerungsfrequenzentspreizungssequenz unterscheidet,

wobei die erste Überlagerungsentspreizungssequenz und die zweite Überlagerungsentspreizungssequenz orthogonal sind.

11. Ein Wasserzeichendecodierer (200; 2560) zum Bereitstellen von binären Nachrichtendaten (202a; 2580) in Abhängigkeit von einem mit einem Wasserzeichen markierten Signal (200a, r(t); 2570), wobei der Wasserzeichendecodierer folgende Merkmale aufweist:

einen Zeit-Frequenz-Bereichsdarstellungsbereitsteller (203; 2590), der dazu konfiguriert ist, eine Zeit-Frequenz-Bereichsdarstellung (204; 2592) des mit einem Wasserzeichen markierten Signals bereitzustellen; und

eine Wasserzeichenextraktionseinrichtung (202; 2596), die eine Entspreizungseinrichtung aufweist, die einen oder mehrere Entspreizungseinrichtungsblöcke aufweist, wobei die Entspreizungseinrichtung dazu konfiguriert ist, eine zweidimensionale Entspreizung durchzuführen, um in Abhängigkeit von einem zweidimensionalen Teil der Zeit-Frequenz-Bereichsdarstellung ein Bit der binären Nachrichtendaten zu erhalten;

wobei die Entspreizungseinrichtung dazu konfiguriert ist, einen Satz von zeitlich entspreizten Werten zu erhalten, wobei die Entspreizungseinrichtung dazu konfiguriert ist, eine Mehrzahl von Werten der Zeit-Frequenz-Bereichsdarstellung mit Werten einer Zeitentspreizungssequenz ($c_t$) zu multiplizieren und Ergebnisse der Multiplikationen zu addieren, um einen der zeitlich entspreizten Werte zu erhalten, und

wobei die Entspreizungseinrichtung dazu konfiguriert ist, die zeitlich entspreizten Werte mit Werten einer Frequenzentspreizungssequenz elementweise zu multiplizieren und Ergebnisse der Multiplikationen zu addieren, um einen zweidimensional entspreizten Wert zu erhalten;

wobei die Entspreizungseinrichtung dazu konfiguriert ist, nachfolgende Sätze von zeitlich entspreizten Werten mit Werten verschiedener Frequenzentspreizungssequenzen elementweise zu multiplizieren, sodass ein erster Satz der zeitlich entspreizten Werte elementweise und in einer einen Schritt oder mehrere Schritte umfassenden Multiplikation mit einer ersten kombinierten Frequenzentspreizungssequenz effektiv multipliziert wird, die ein Produkt einer gemeinsamen Frequenzentspreizungssequenz und einer ersten Überlagerungsentspreizungssequenz ist,

und sodass ein zweiter Satz der zeitlich entspreizten Werte elementweise und in einer einen Schritt oder mehrere Schritte umfassenden Multiplikation effektiv mit einer zweiten kombinierten Frequenzentspreizungssequenz multipliziert wird, die ein Produkt der gemeinsamen Frequenzentspreizungssequenz und einer zweiten Überlagerungsentspreizungssequenz ist, die sich von der ersten Überlagerungsfrequenzentspreizungssequenz unterscheidet,

wobei die erste Überlagerungsentspreizungssequenz und die zweite Überlagerungsentspreizungssequenz orthogonal sind.

12. Der Wasserzeichendecodierer gemäß Anspruch 10 oder Anspruch 11, bei dem die Entspreizungseinrichtung dazu konfiguriert ist, eine Mehrzahl von Werten der Zeit-Frequenz-Bereichsdarstellung (1377) mit Werten einer Zeitentspreizungssequenz ($c_f$) zu multiplizieren und Ergebnisse der Multiplikationen zu addieren, um einen zeitlich entspreizten Wert (1378) zu erhalten, und

bei dem die Entspreizungseinrichtung dazu konfiguriert ist, eine Mehrzahl von zeitlich entspreizten Werten, die verschiedenen Frequenzen der Zeit-Frequenz-Bereichsdarstellung zugeordnet sind, oder von davon abgeleiteten Werten elementweise mit einer Frequenzentspreizungssequenz ($c_f$) zu multiplizieren und Ergebnisse der Multiplikation zu addieren, um einen zweidimensional entspreizten Wert zu erhalten.

13. Der Wasserzeichendecodierer gemäß einem der Ansprüche 10 bis 12, bei dem die Entspreizungseinrichtung dazu konfiguriert ist, einen Satz von zeitlich entspreizten Werten zu erhalten, wobei die Entspreizungseinrichtung dazu konfiguriert ist, eine Mehrzahl von Werten der Zeit-Frequenz-Bereichsdarstellung mit Werten einer Frequenzentspreizungssequenz ($c_f$) zu multiplizieren und Ergebnisse der Multiplikationen zu addieren, um einen der zeitlich entspreizten Werte zu erhalten, und
wobei die Entspreizungseinrichtung dazu konfiguriert ist, die zeitlich entspreizten Werte mit Werten einer Frequenzentspreizungssequenz elementweise zu multiplizieren und Ergebnisse der Multiplikationen zu addieren, um einen zweidimensional entspreizten Wert zu erhalten.

14. Der Wasserzeichendecodierer gemäß Anspruch 13, bei dem die Entspreizungseinrichtung dazu konfiguriert ist, nachfolgende Sätze von zeitlich entspreizten Werten mit Werten verschiedener Frequenzentspreizungssequenzen elementweise zu multiplizieren, sodass ein erster Satz der zeitlich entspreizten Werte elementweise und in einer einen Schritt oder mehrere Schritte umfassenden Multiplikation mit einer ersten kombinierten Frequenzentspreizungssequenz effektiv multipliziert wird, die ein Produkt einer gemeinsamen Frequenzentspreizungssequenz und einer ersten Überlagerungsentspreizungssequenz ist, und sodass ein zweiter Satz der zeitlich entspreizten Werte elementweise und in einer einen Schritt oder mehrere Schritte umfassenden Multiplikation effektiv mit einer zweiten kombinierten Frequenzentspreizungssequenz multipliziert wird, die ein Produkt der gemeinsamen Frequenzentspreizungssequenz und einer zweiten Überlagerungsentspreizungssequenz ist, die sich von der ersten Überlagerungsfrequenz-entspreizungssequenz unterscheidet.

15. Ein Verfahren (2600) zum Bereitstellen eines Wasserzeichensignals in Abhängigkeit von binären Nachrichtendaten, wobei das Verfahren folgende Schritte aufweist:

Bereitstellen (2610), in Abhängigkeit von einem einzelnen Nachrichtenbit der binären Nachrichtendaten, von zweidimensionalen gespreizten Informationen, die das Nachrichtenbit in Form eines Satzes von Zeit-Frequenz-Bereichswerten darstellen; und
Bereitstellen (2620) des Wasserzeichensignals auf der Basis der zweidimensionalen gespreizten Informationen; wobei ein erstes Nachrichtenbit in einer ersten Spreizrichtung unter Verwendung einer ersten Spreizsequenz ($c_f$) gespreizt wird und ein zweites Nachrichtenbit in der ersten Spreizrichtung unter Verwendung der ersten Spreizsequenz ($c_f$) gespreizt wird, um eine Zwischeninformationsdarstellung (303a, $c_f \cdot m$) zu erhalten, und wobei die Zwischeninformationsdarstellung mit einer Überlagerungsinformationsdarstellung (S) kombiniert wird, um eine kombinierte Informationsdarstellung (C) zu erhalten, und wobei die kombinierte Informationsdarstellung in einer zweiten Richtung unter Verwendung einer zweiten Spreizsequenz ($c_t$) gespreizt wird, um die zweidimensionalen gespreizten Informationen zu erhalten,
wobei die Zwischeninformationsdarstellung mit einer Überlagerungsinformationsdarstellung kombiniert wird, die in der ersten Spreizrichtung unter Verwendung einer Mehrzahl von Überlagerungsinformationsspreizsequenzen (a,b) gespreizt wird, derart, dass das erste gespreizte Nachrichtenbit mit einer ersten Überlagerungsinformationsspreizsequenz (a) multipliziert wird, und derart, dass das zweite gespreizte Nachrichtenbit mit einer zweiten Überlagerungsinformationsspreizsequenz (b) multipliziert wird,
wobei die erste Überlagerungsinformationsspreizsequenz und die zweite Überlagerungsinformationsspreizsequenz orthogonal sind.

16. Ein Verfahren (2700) zum Bereitstellen von binären Nachrichtendaten in Abhängigkeit von einem mit einem Wasserzeichen markierten Signal, wobei das Verfahren folgende Schritte aufweist:

Bereitstellen (2710) einer Zeit-Frequenz-Bereichsdarstellung des mit einem Wasserzeichen markierten Signals; und
Durchführen (2720) einer zweidimensionalen Entspreizung, um ein Bit der binären Nachrichtendaten oder Synchronisationsinformationen zu erhalten, die dazu verwendet werden, die binären Nachrichtendaten aus der Zeit-Frequenz-Bereichsdarstellung des Wasserzeichensignals zu extrahieren, in Abhängigkeit von einem zweidimensionalen Teil der Zeit-Frequenz-Bereichsdarstellung;
wobei ein Satz von zeitlich entspreizten Werten erhalten wird, wobei eine Mehrzahl von Werten der Zeit-Frequenz-Bereichsdarstellung mit Werten einer Zeitentspreizungssequenz ($c_t$) multipliziert wird und wobei Ergebnisse der Multiplikationen addiert werden, um einen der zeitlich entspreizten Werte zu erhalten, und
wobei die zeitlich entspreizten Werte mit Werten einer Frequenzentspreizungssequenz elementweise multipliziert werden und wobei Ergebnisse der Multiplikationen addiert werden, um einen zweidimensional entspreizten Wert zu erhalten;
wobei nachfolgende Sätze von zeitlich entspreizten Werten mit Werten verschiedener Frequenzentspreizungssequenzen elementweise multipliziert werden, sodass ein erster Satz der zeitlich entspreizten Werte elementweise und in einer einen Schritt oder mehrere Schritte umfassenden Multiplikation mit einer ersten kombinierten Frequenzentspreizungssequenz effektiv multipliziert wird, die ein Produkt einer gemeinsamen Frequenzentspreizungssequenz und einer ersten Überlagerungsentspreizungssequenz ist, und sodass ein zweiter Satz der zeitlich entspreizten Werte elementweise und in einer einen Schritt oder mehrere Schritte umfassenden Multiplikation effektiv mit einer zweiten kombinierten Frequenzentspreizungssequenz multipliziert wird, die ein Produkt der gemeinsamen Frequenzentspreizungssequenz und einer zweiten Überlagerungsentspreizungssequenz ist, die sich von der ersten Überlagerungsfrequenz-entspreizungssequenz unterscheidet, wobei die erste Überlagerungsentspreizungssequenz und die zweite Überlagerungsentspreizungssequenz orthogonal sind.

**17.** Ein Computerprogramm, das dazu angepasst ist, das Verfahren gemäß Anspruch 15 oder Anspruch 16 auszuführen, wenn das Computerprogramm auf einem Computer abläuft.

## Revendications

**1.** Générateur de filigrane (101; 2400) pour fournir un signal de filigrane (101b; 2420) en fonction de données de message binaires (10 la, m; 2410), le générateur de filigrane comprenant:

un processeur d'informations (303, 304, 305) configuré pour fournir, en fonction d'un seul bit de message des données de message binaires, une information étalée bidimensionnelle (b(i, j); 2432) représentant le bit de message sous forme d'un ensemble de valeurs dans le domaine temporel-fréquentiel; et
un fournisseur de signal de filigrane (306, 307) configuré pour fournir le signal de filigrane sur base de l'information étalée bidimensionnelle;
dans lequel le processeur d'informations est configuré pour étaler un premier bit de message dans une première direction d'étalement à l'aide d'une première séquence étalée ($c_f$) et pour étaler un deuxième bit de message dans la première direction d'étalement à l'aide de la première séquence étalée ($c_f$), afin d'obtenir une représentation d'informations intermédiaire (303a,
$c_f \cdot$ **m**), pour combiner la représentation d'informations intermédiaire avec une représentation d'informations de superposition (**S**), afin d'obtenir une représentation d'informations combinée (**C**), et pour étaler la représentation d'informations combinée dans une deuxième direction à l'aide d'une deuxième séquence étalée ($c_t$), afin d'obtenir les informations étalées bidimensionnelles,
dans lequel le processeur d'informations est configuré pour combiner la représentation d'informations intermédiaire avec une représentation d'informations de superposition qui est étalée dans la première direction d'étalement à l'aide d'une pluralité de séquences d'étalement (**a**, **b**) d'informations de superposition de sorte que le premier bit de message étalé soit multiplié par une première séquence étalée d'informations de superposition (**a**), et de sorte que le deuxième bit de message étalé soit multiplié par une deuxième séquence étalée (**b**) d'informations de superposition,
dans lequel la première séquence étalée d'informations de superposition et la deuxième séquence étalée d'informations de superposition sont orthogonales.

**2.** Générateur de filigrane selon la revendication 1, dans lequel la première séquence étalée ($c_f$) comprend une grandeur $N_f$ x 1, où $N_f$ est une largeur d'étalement de fréquence.

**3.** Générateur de filigrane selon la revendication 1 ou la revendication 2, dans lequel la première séquence étalée définit un étalement uniquement dans la direction de la fréquence.

**4.** Générateur de filigrane selon l'une des revendications 1 à 2, dans lequel le processeur d'informations est configuré pour étaler le bit de message dans une première direction d'étalement à l'aide d'une première séquence étalée ($c_f$), afin d'obtenir une représentation d'informations intermédiaire (303a, $c_f \cdot$ **m**), pour combiner la représentation d'informations intermédiaire avec une représentation d'informations de superposition (**S**), afin d'obtenir une représentation d'informations combinée (**C**), et pour étaler la représentation d'informations combinée dans une deuxième direction à l'aide d'une deuxième séquence étalée ($c_t$), afin d'obtenir les informations étalées bidimensionnelles.

**5.** Générateur de filigrane selon la revendication 4, dans lequel le processeur d'informations est configuré pour combiner la représentation d'informations intermédiaire avec une représentation d'informations de superposition qui est étalée dans la première direction d'étalement à l'aide d'une séquence d'étalement d'informations de superposition (**a**), de sorte que le bit de message et les informations de superposition soient étalés avec différentes séquences d'étalement ($c_f$, **a**) dans la première direction d'étalement, et de sorte que la combinaison du bit de messages et des informations de superposition soit étalée avec une séquence d'étalement commune ($c_t$) dans la deuxième direction d'étalement.

6. Générateur de filigrane selon la revendication 4 ou 5, dans lequel le processeur d'informations est configuré pour combiner de manière multiplicative la représentation d'informations intermédiaire (303a, $c_f \cdot m$) avec la représentation d'information de superposition (**S**), et pour étaler la représentation d'informations combinée qui comprend des valeurs de produit formées en fonction de valeurs de la représentation d'informations intermédiaire et de valeurs des informations de recouvrement, dans la deuxième direction d'étalement à l'aide de la deuxième séquence ($c_t$), de sorte que les valeurs de produit soient étalées à l'aide d'une séquence étalée commune.

7. Générateur de filigrane selon l'une des revendications 1 à 2 et 4 à 6, dans lequel le processeur d'informations est configuré pour étaler de manière sélective un bit de message donné sur une première représentation de bit, qui est un multiple positif d'une séquence étalée de bits ($c_f$), ou sur une deuxième représentation de bits, qui est un multiple négatif de la séquence étalée de bits ($c_f$), en fonction de la valeur du bit donné, pour étaler le bit de message dans la première direction d'étalement.

8. Générateur de filigrane selon l'une des revendications 1 à 2 et 4 à 7, dans lequel le processeur d'informations est configuré pour mapper une valeur donnée d'une représentation d'informations intermédiaire qui est obtenue en étalant le bit de message dans la première direction d'étalement,
ou une valeur donnée d'une représentation d'informations combinée qui est combinée en étalant le bit de message dans la première direction d'étalement et en combinant le résultat avec une représentation d'informations de superposition,
sur un ensemble de valeurs étalées de sorte que l'ensemble de valeurs étalées soit une version échelonnée d'une deuxième séquence étalée ($c_t$) échelonnée selon la valeur donnée.

9. Générateur de filigrane selon l'une des revendications 1 à 2 et 4 à 8, dans lequel le processeur d'informations est configuré pour obtenir, comme représentation d'informations intermédiaire, une représentation d'informations étalées R selon

$$\mathbf{R} = \mathbf{c_f} \cdot \mathbf{m},$$

où $c_f$ est un vecteur de grandeur $N_f$ x 1 représentant une séquence d'étalement de bits de largeur d'étalement de fréquence $N_f$,
où **m** est un vecteur de grandeur 1 x $N_{mc}$ représentant $N_{mc}$ bits des données de message binaires, où différentes valeurs binaires des bits sont représentées par les entrées du vecteur **m** présentant un signe différent et
où "·" désigne un opérateur de multiplication de matrice; et
dans lequel le processeur d'informations est configuré pour obtenir les informations étalées bidimensionnelles **B** à l'aide d'une opération

$$\mathbf{B} = \mathbf{R'} \lozenge \mathbf{c_t^T},$$

où **R'** est égal à **R** ou obtenu en combinant **R** avec une information de superposition (**S**);
où $\lozenge$ désigne un opérateur de produit de Kronecker, et
où T désigne un opérateur de transposition.

10. Décodeur de filigrane (200; 2500) pour fournir des données de message binaires (202a; 2520) en fonction d'un signal à filigrane (200a, r(t); 2510), le décodeur de filigrane comprenant:

un fournisseur de représentation dans le domaine temporel-fréquentiel (203; 2530) configuré pour fournir une représentation dans le domaine temporel-fréquentiel (204; 2532) du signal à filigrane;
un déterminateur de synchronisation (201; 2540) comprenant un désétaleur présentant un ou plusieurs blocs de désétaleur (1201, 1203; 2542), dans lequel le désétaleur est configuré pour réaliser un désétalement bidimensionnel, afin d'obtenir une information de synchronisation (205; 2544) en fonction d'une partie bidimensionnelle de la représentation dans le domaine temporel-fréquentiel; et
un extracteur de filigrane (202; 2550) configuré pour extraire les données de message binaires de la représentation dans le domaine temporel-fréquentiel du signal à filigrane à l'aide des informations de synchronisation;

dans lequel le désétaleur est configuré pour obtenir un ensemble de valeurs désétalées temporairement, dans lequel le désétaleur est configuré pour multiplier une pluralité de valeurs de représentation dans le domaine temporel-fréquentiel par des valeurs d'une séquence désétalée dans le temps ($c_t$), et pour additionner les résultats des multiplications, afin d'obtenir l'une des valeurs désétalées dans le temps, et

dans lequel le désétaleur est configuré pour multiplier les valeurs désétalées dans le temps par des valeurs d'une séquence désétalée en fréquence par élément, et pour additionner les résultats de la multiplication, pour obtenir une valeur désétalée bidimensionnellement;

dans lequel le désétaleur est configuré pour multiplier les ensembles successifs de valeurs désétalées dans le temps par les valeurs de différentes séquences désétalées en fréquence par élément, de sorte qu'un premier ensemble de valeurs désétalées dans le temps soit effectivement multiplié, par élément et par une multiplication en une seule étape ou en de multiples étapes, par une première séquence désétalée en fréquence combinée, qui est un produit d'une séquence désétalée en fréquence commune et

d'une première séquence désétalée de superposition, et de sorte qu'un deuxième ensemble de valeurs désétalées dans le temps soit effectivement multiplié, par élément et par une multiplication en une seule étape ou en de multiples étapes, par une deuxième séquence désétalée en fréquence combinée, qui est un produit de la séquence désétalée en fréquence commune et d'une deuxième séquence désétalée de superposition qui est différente de la première séquence désétalée en fréquence de superposition,

dans lequel la première séquence désétalée de superposition et la deuxième séquence désétalée de superposition sont orthogonales.

11. Décodeur de filigrane (200; 2560) pour fournir des données de message binaires (202a; 2580) en fonction d'un signal à filigrane (200a, r(t); 2570,) le décodeur de filigrane comprenant:

un fournisseur de représentation dans le domaine temporel-fréquentiel (203; 2590) configuré pour fournir une représentation dans le domaine temporel-fréquentiel (204; 2592) du signal à filigrane; et

un extracteur de filigrane (202; 2596) comprenant un désétaleur présentant un ou plusieurs blocs de désétaleur, où le désétaleur est configuré pour réaliser un désétalement bidimensionnel afin d'obtenir un bit des données de message binaires en fonction d'une partie bidimensionnelle de la représentation dans le domaine temporel-fréquentiel;

dans lequel le désétaleur est configuré pour obtenir un ensemble de valeurs désétalées dans le temps, où le désétaleur est configuré pour multiplier une pluralité de valeurs de représentation dans le domaine temporel-fréquentiel par des valeurs d'une séquence désétalée dans le temps ($c_t$), et pour additionner les résultats des multiplications, afin d'obtenir l'une des valeurs désétalées dans le temps, et

dans lequel le désétaleur est configuré pour multiplier les valeurs désétalées dans le temps par des valeurs d'une séquence désétalée en fréquence par élément, et pour additionner les résultats de la multiplication, afin d'obtenir une valeur désétalée bidimensionnellement;

dans lequel le désétaleur est configuré pour multiplier les ensembles successifs de valeurs désétalées dans le temps par les valeurs de différentes séquences désétalées en fréquence par élément, de sorte qu'un premier ensemble de valeurs désétalées dans le temps soit effectivement multiplié, par élément et par une multiplication en une seule étape ou en de multiples étapes, par une première séquence désétalée en fréquence combinée, qui est un produit d'une séquence désétalée en fréquence commune et

d'une première séquence désétalée de superposition, et de sorte qu'un deuxième ensemble de valeurs désétalées dans le temps soit effectivement multiplié, par élément et par une multiplication en une seule étape ou en de multiples étapes, par une deuxième séquence désétalée en fréquence combinée, qui est un produit de la séquence désétalée en fréquence commune et d'une deuxième séquence désétalée de superposition qui est différente de la première séquence désétalée en fréquence de superposition,

dans lequel la première séquence désétalée de superposition et la deuxième séquence désétalée de superposition sont orthogonales.

12. Décodeur de filigrane selon la revendication 10 ou 11, dans lequel le désétaleur est configuré pour multiplier une pluralité de valeurs de représentation dans le domaine temporel-fréquentiel (1377) par des valeurs d'une séquence désétalée dans le temps ($c_f$) et pour additionner les résultats des multiplications, afin d'obtenir une valeur désétalée dans le temps (1378), et

dans lequel le désétaleur est configuré pour déterminer une pluralité de valeurs désétalées dans le temps associées à différentes fréquences de la représentation dans le domaine temporel-fréquentiel, ou des valeurs dérivées de ces dernières, par une séquence désétalée en fréquence ($c_f$) par élément et pour additionner les résultats de la multiplication, afin d'obtenir une valeur désétalée bidimensionnellement.

**13.** Décodeur de filigrane selon l'une des revendications 10 à 12, dans lequel le désétaleur est configuré pour obtenir un ensemble de valeurs désétalées dans le temps, dans lequel le désétaleur est configuré pour multiplier une pluralité de valeurs de la représentation dans le domaine temporel-fréquentiel par des valeurs d'une séquence désétalée dans le temps ($c_t$), et pour additionner les résultats des multiplications, afin d'obtenir l'une des valeurs désétalées dans le temps, et

dans lequel le désétaleur est configuré pour multiplier les valeurs désétalées dans le temps par des valeurs d'une séquence désétalée en fréquence par élément, et pour additionner les résultats des multiplications pour obtenir une valeur désétalée bidimensionnellement.

**14.** Décodeur de filigrane selon la revendication 13, dans lequel le désétaleur est configuré pour multiplier des ensembles successifs de valeurs désétalées dans le temps par les valeurs de différentes séquences désétalées en fréquence par élément, de sorte qu'un premier ensemble de valeurs désétalées dans le temps soit effectivement multiplié, par élément et par une multiplication en une seule étape ou en de multiples étapes, par une première séquence désétalée en fréquence combinée, qui est un produit d'une séquence désétalée en fréquence commune et d'une première séquence désétalée de superposition, et de sorte qu'un deuxième ensemble de valeurs désétalées dans le temps soit effectivement multiplié, par élément et par une multiplication en une seule étape ou en de multiples étapes, par une deuxième séquence désétalée en fréquence combinée, qui est un produit de la séquence désétalée en fréquence commune et d'une deuxième séquence désétalée de superposition qui est différente de la première séquence désétalée en fréquence de superposition,

**15.** Procédé (2600) pour fournir un signal de filigrane en fonction de données de message binaires, le procédé comprenant le fait de:

fournir (2610), en fonction d'un seul bit de message des données de message binaires, une information d'étalement bidimensionnelle représentant le bit de message sous forme d'un ensemble de valeurs dans le domaine temporel-fréquentiel; et

fournir (2620) le signal de filigrane sur base des informations d'étalement bidimensionnelles;

dans lequel un premier bit de message est étalé dans une première direction d'étalement à l'aide d'une première séquence étalée ($c_f$), et un deuxième bit de message est étalé dans la première direction d'étalement à l'aide de la première séquence étalée ($c_f$), pour obtenir une représentation d'informations intermédiaire (303a, $c_f \cdot$ **m**), et dans lequel la représentation d'informations intermédiaire est combinée avec une représentation d'informations de superposition (**S**), afin d'obtenir une représentation d'informations combinée (**C**), et dans lequel la représentation d'informations combinée est étalée dans une deuxième direction à l'aide d'une deuxième séquence étalée ($c_t$), afin d'obtenir les informations étalées bidimensionnelles,

dans lequel la représentation d'informations intermédiaire est combinée avec une représentation d'informations de superposition qui est étalée dans la première direction d'étalement à l'aide d'une pluralité de séquences d'étalement (**a**, **b**) d'informations de superposition de sorte que le premier bit de message étalé soit multiplié par une première séquence d'étalement d'informations de superposition (**a**), et de sorte que le deuxième bit de message étalé soit multiplié par une deuxième séquence étalée (**b**) d'informations de superposition,

dans lequel la première séquence étalée d'informations de superposition et la deuxième séquence étalée d'informations de superposition sont orthogonales.

**16.** Procédé (2700) pour fournir des données de message binaires en fonction d'un signal à filigrane, le procédé comprenant le fait de:

fournir (2710) une représentation dans le domaine temporel-fréquentiel du signal à filigrane; et

effectuer (2720) un désétalement bidimensionnel afin d'obtenir un bit des données de message binaires ou une information de synchronisation utilisée pour extraire les données de message binaires de la représentation dans le domaine temporel-fréquentiel du signal de filigrane en fonction d'une partie bidimensionnelle de la représentation dans le domaine temporel-fréquentiel;

dans lequel est obtenu un ensemble de valeurs désétalées dans le temps, dans lequel une pluralité de valeurs de la représentation dans le domaine temporel-fréquentiel sont multipliées par les valeurs d'une séquence désétalée dans le temps ($c_t$), et dans lequel les résultats des multiplications sont additionnés afin d'obtenir l'une des valeurs désétalées dans le temps, et

dans lequel les valeurs désétalées dans le temps sont multipliées par les valeurs d'une séquence désétalée en fréquence par élément, et dans lequel les résultats des multiplications sont additionnés pour obtenir une valeur désétalée bidimensionnellement;

dans lequel des ensembles successifs de valeurs désétalées dans le temps sont multipliés par les valeurs de différentes séquences désétalées en fréquence par élément, de sorte qu'un premier ensemble de valeurs désétalées dans le temps soit effectivement multiplié, par élément et par une multiplication en une seule étape ou en de multiples étapes, par une première séquence désétalée en fréquence combinée, qui est un produit d'une séquence désétalée en fréquence commune et d'une première séquence désétalée de superposition, et de sorte qu'un deuxième ensemble de valeurs désétalées dans le temps soit effectivement multiplié, par élément et par une multiplication en une seule étape ou en de multiples étapes, par une deuxième séquence désétalée en fréquence combinée, qui est un produit de la séquence désétalée en fréquence commune et d'une deuxième séquence désétalée de superposition qui est différente de la première séquence désétalée en fréquence de superposition,

dans lequel la première séquence désétalée de superposition et la deuxième séquence désétalée de superposition sont orthogonales.

17. Programme d'ordinateur adapté pour réaliser le procédé selon la revendication 15 ou la revendication 16 lorsque le programme d'ordinateur est exécuté sur un ordinateur.

FIGURE 1

EP 2 522 013 B1

EP 2 522 013 B1

FIGURE 2

101 watermark generator

**FIGURE 3**

EP 2 522 013 B1

307 modulator

$b_{diff}$ (i=1,j) 101 → 411 bit shaping → 421 → $s_{i=1}(t)$

402 → bit shaping → 422 →

412

$41N_f$

$b_{diff}$ (i=$N_f$,j) $40N_f$ → bit shaping → $42N_f$ → $s_{i=N_f}(t)$

104 ••• 105

⊕ → watermark signal $\sum s_i(t)$

psychoacoustical processing module 102

FIGURE 4

38

102
psychoacoustical
processing module

106

time/freq. analysis 501

504

psychoacoustical
model 502

505

amplitude calculation 503

105 104

FIGURE 5

504

505

502
psychoaccoustical
model
processor

spectral smoothing 801

"frequency masking"
threshold computation 802

"time masking"
threshold computation 805

multi-resolution merging 806

FIGURE 6

FIGURE 7

FIGURE 8

EP 2 522 013 B1

505

503
amplitude
calculator

amplitude calculation ── 901

amplitudes adaptation ── 902

105 ── ──104

FIGURE 9

FIGURE 10A

EP 2 522 013 B1

FIGURE 10B

EP 2 522 013 B1

204
(optionally
oversampled)

201
synchronization
module

1201

synchronization
signature correlator

1201a

synchronization
hits computation

1204

205

FIGURE 11A

EP 2 522 013 B1

201
synchronization
module

204

1201
time
despreading

1202
synchronization
sequences

1203
frequency
despreading

synchronization
signal computation
1204

205

FIGURE 11B

FIGURE 12A

message k-1                    message k                    message k+1

1299b

# FIGURE 12B

a b c d e f = synchronization sequence

synchronization hits

# FIGURE 12C

= synchronization sequence

synchronization hits

FIGURE 12D

FIGURE 12E

EP 2 522 013 B1

F 12F

EP 2 522 013 B1

synchronization
signature correlator
1201

204

1301

1301a

time
despreading

synchronization signature
multiplication

1302

1302a

frequency
despreading

1303

1303a

likelihood measure
computation

1304

1201a

FIGURE 12G

candidate synchronization hit

value of time-frequency domain representation

frequency

Tb

1    c    a     a     b     b     c     c     a     a     b     b     c

204

Nf

$N_{os}$

time

search block k

search block k+1

time despread values

1377

time despread

(block 1302)

1301a

1378

$N_t \cdot N_s$

$c_t$

FIGURE 13A

EP 2 522 013 B1

sequence of synchronization
spread sequences a, b, c

a  b  c

Cf

time-
despread
values

1302a

1303a

1303ab

1303aa

X

element-wise
multiplication

X

vector product

|·|

|·|

|·|

summing

1301aa

1301ab

1302ac

1301a

synch. seq.
multiplication
(block 1302)

frequency
despreading
(block 1303)

absolute
value
formation

FIGURE 13B

output of 1201 after temporal averaging

synch hit

**FIGURE 13C**

autocorrelation function

output of 1201 after temporal averaging

synch hit

**FIGURE 13D**

FIGURE 14

EP 2 522 013 B1

FIGURE 15

EP 2 522 013 B1

EP 2 522 013 B1

203 analysis module

watermarked audio signal

200a

1600

analysis filter bank

$b_i^{AFB}(j)$

1604

amplitude normalization

$b_i^{norm}(j)$

1608

differential decoding

$\hat{b}_i(j)$

204

FIGURE 16

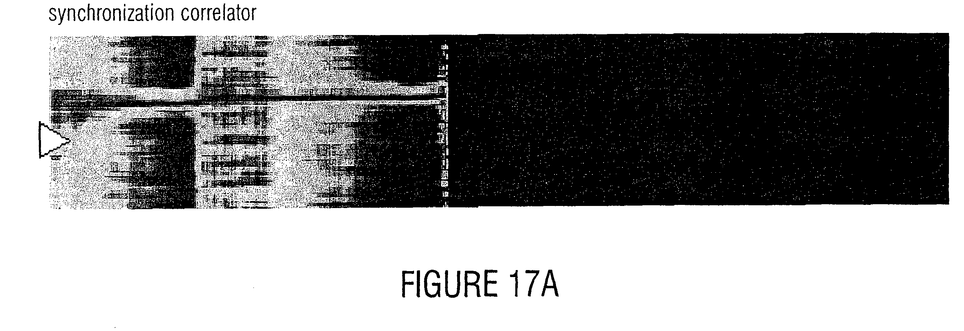

FIGURE 17A

synchronization correlator

decoded messages

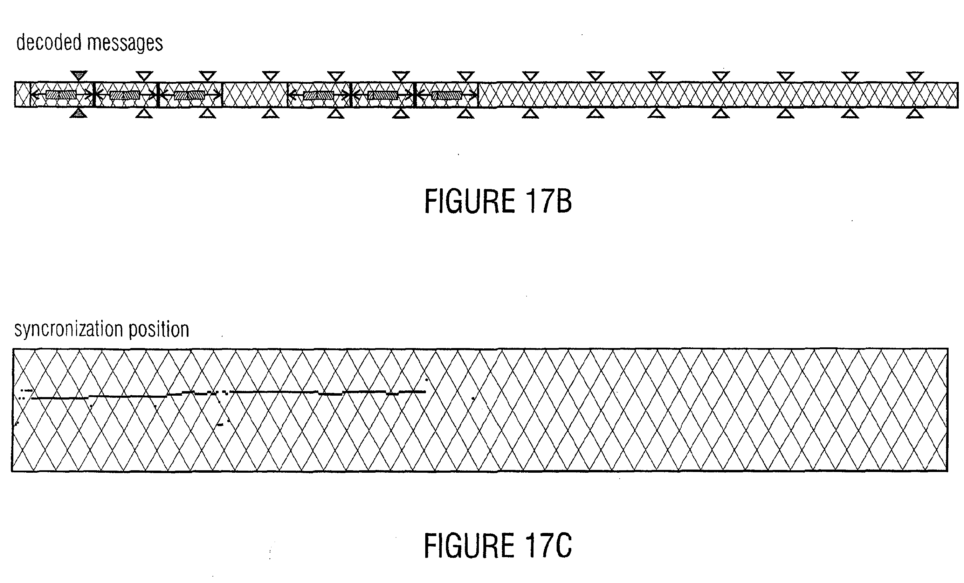

# FIGURE 17B

syncronization position

# FIGURE 17C

EP 2 522 013 B1

1810

1810 1820

1830

1840

FIGURE 18A

intensity

~75 Hz

1.5 kHz          6 kHz          f

FIGURE 18B

EP 2 522 013 B1

1900

**ABC synch - the basic concept**

message (uncoded) — 1910

message (coded)

A B C D — 1930 · 1920 · synch sequence

**synch applied to messages**

A B C D A B C D A B C D A B C D A B C D A B C D A B C D A B C D A B C D A B C D A B C D A B C D • • •

1920 · 1920 · 1920

FIGURE 19

ABC synch - the basic concept

message (uncoded) ~1910

message (coded)

synch sequence

A B C D ~1930

1920

synch applied to messages

1920                    1920

A B C D A B C D A B C D A B C D A B C D A B C D A B C D A B C D A B C D A B C D A B C D A B C D • • •

1940  1940  1940  1940  1940                    1940

1. synchronization is found by correlating with the synch sequence

FIGURE 20

EP 2 522 013 B1

## ABC synch - the basic concept

A rectangular box ~1910 — message (uncoded)

A wider rectangular box — message (coded)

`A B C D` ~1930 / 1920 — synch sequence

## synch applied to messages

`A B C D A B C D A B C D A B C D A B C D A B C D A B C D A B C D A B C D A B C D A B C D A B C D` •••

1920      1920

1940  1940  1940  1940  1940  1940      •••

2110  2110  2110  2110  2110  2110

2. for each synch found          a Viterbi decoder ( ▷ ) may be started

FIGURE 21

EP 2 522 013 B1

ABC synch - the basic concept

message (coded)

A B C D ~1930    1920    synch sequence

synch applied to messages

A B C D A B C D A B C D A B C D A B C D A B C D A B C D A B C D A B C D A B C D A B C D A B C D • • •

1920    1920

2210

message 1

2210

message 2

3. true messages are indentified by means of a CRC sequences and/or a plausibility check

FIGURE 22

payload                                    CRC

# FIGURE 23

2400

watermark generator

binary
message
data

2430

information
processor

2-dimensional
spread formation

2440

watermark
signal provider

watermark
signal

2410

2432

2420

FIGURE 24

FIGURE 25A

EP 2 522 013 B1

2560

2590

time-
frequency-
domain
representation
provider

2570

2592

time-frequency-
domain representation

2596

watermark
extractor

despreader

2598

binary
message
data

2580

FIGURE 25B

2600

Providing, in dependence on a single message bit of the
binary message data, a 2-dimensional spread information
representing the message bit in the form of a set of
time-frequency-domain values; and

~2610

providing the watermark signal on the basis of the
2-dimensional spread information.

~2620

## FIGURE 26

Providing a time-frequency-domain representation
of the watermarked signal; and

~271ʳ

performing a 2-dimensional despreading in order to obtain
a bit of the binary message data or a synchronization
information used to extract the binary message data from
the time-frequency-domain representation of the
watermark signal in depdence on a 2-dimensional portion
of the time-frequency-domain representation.

~272

## FIGURE 27

**EP 2 522 013 B1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- DE 19640814 C2
- WO 9307689 A
- US 5450490 A
- WO 9411989 A
- WO 9527349 A
- DE 19640814

**Non-patent literature cited in the description**

- **KIROVSKI D et al.** Robust Covert communication over a Public Audio Channel using Spread Spectrum. *LECTURE NOTES IN COMPUTER SCIENCE,* 01 January 2001, vol. 2137, 354-368